# EUROPEAN PATENT APPLICATION

(11) **EP 4 672 939 A1**
(43) Date of publication of application: **31.12.2025**
(21) Application number: 25184192.0
(22) Date of filing: 20.06.2025
(51) Int. Cl.: H10K 59/131, H10K 59/35, H10K 65/00

(54) **DISPLAY DEVICE AND ELECTRONIC DEVICE INCLUDING THE SAME**

(30) Priority: 25.06.2024 KR 20240082790
(71) Applicant: Samsung Display Co., Ltd., Yongin-si, Gyeonggi-do 17113 (KR)
(72) Inventor: SHIN, Dong Hee, 17113 Yongin-si, Gyeonggi-do (KR); SON, Sun Kwun, 17113 Yongin-si, Gyeonggi-do (KR)
(74) Representative: Gulde & Partner

(57) **Abstract**

A display device (DD, 1060) includes: a first sub-pixel (SPX1), a second sub-pixel (SPX2), and a third sub-pixel (SPX3) arranged along a first direction (DR1), each of the first to third sub-pixels (SPX1 - SPX3) includes a pixel circuit (PXC); a light-sensing pixel (PSR) including a sensor circuit (SC); a data line (D) electrically connected to each of the second and third sub-pixels (SP2, SPX3); a readout line (RX) electrically connected to the light-sensing pixel (PSR); a horizontal bridge line (BRL1_H, BRL2_H) extending along the first direction (DR1); a first vertical bridge line (BRL1_V) extending in a second direction (DR2) and is located in the second sub-pixel (SPX2); and a second vertical bridge line (BRL2_V) extending in the second direction (DR2) and is located in the third sub-pixel (SPX3). In a plan view, the second vertical bridge line (BRL2_V) may be between the readout line (RX) and the data line (D) of the third sub-pixel (SPX3). The second vertical bridge line (BRL2_V) may include a first sub-electrode (SUE1) and a second sub-electrode (SUE2) that are spaced from each other.

## Description

### BACKGROUND

### 1. Field

The present disclosure relates to a display device and an electronic device including the same.

### 2. Description of the Related Art

In recent years, as interest in information displays has increased, research and development of display devices has been carried out continuously.

### SUMMARY

The present disclosure may provide a display device with enhanced reliability and an electronic device including the same.

A display device according to one or more embodiments may include: a first sub-pixel, a second sub-pixel, and a third sub-pixel arranged along a first direction, each of the first to third sub-pixels includes a pixel circuit; a light-sensing pixel including a sensor circuit; a data line electrically connected to each of the second and third sub-pixels; a readout line electrically connected to the light-sensing pixel; a horizontal bridge line extending along the first direction; a first vertical bridge line extending in a second direction and is located in the second sub-pixel; and a second vertical bridge line extending in the second direction and is located in the third sub-pixel. In a plan view, the second vertical bridge line may be between the readout line and the data line of the third sub-pixel. The second vertical bridge line may include a first sub-electrode and a second sub-electrode that are spaced from each other.

The first sub-electrode may be electrically connected to the horizontal bridge line. The first sub-electrode and the second sub-electrode may be electrically disconnected from each other.

The data line, the first vertical bridge line, and the second vertical bridge line may be arranged at a same layer.

The display device may further include a reset voltage wire electrically connected to the light-sensing pixel and which may be configured to receive a reset voltage. The reset voltage wire may include a first wire at a same layer as the data line and the first and second vertical bridge lines and spaced from each other; a second wire below the first wire and electrically connected to the first wire; and a third wire below the second wire and electrically connected to the second wire.

The third wire may extend in the first direction, the second wire may extend in the second direction, and the first wire may extend in the second direction. The reset voltage wire may form a mesh structure.

The display device may further include a first power wire electrically connected to each of the first to third sub-pixels and which may be configured to receive a first driving voltage; a second power wire electrically connected to each of the first to third sub-pixels and which may be configured to receive a second driving voltage; and a third power wire electrically connected to each of the first to third sub-pixels and which may be configured to receive a third driving voltage. Each of the first driving voltage, the second driving voltage, and the third driving voltage may be a direct current voltage having a constant voltage level.

The second sub-electrode may be electrically connected to at least one of the first power wire, the second power wire, or the third power wire.

The second sub-electrode may be electrically connected to the first power wire.

The second sub-electrode may be electrically connected to the second power wire.

The second sub-electrode may be electrically connected to the third power wire.

The light-sensing pixel may be located between the second sub-pixel and the third sub-pixel.

Each of the first sub-pixel, the second sub-pixel, and the third sub-pixel may include a light-emitting element configured to emit light. The light-sensing pixel may include a light-receiving element configured to output a sensing signal corresponding to the light.

The first sub-electrode and the second sub-electrode may be electrically disconnected and located in a same column along the second direction.

The display device may further include a first via layer on the horizontal bridge line and including a first via hole exposing an area of the horizontal bridge line; a pad electrode on the first via layer and electrically connected to the horizontal bridge line through the first via hole; and a second via layer on the pad electrode and including a second via hole exposing an area of the pad electrode. In a plan view, the second vertical bridge line may be separated into the first sub-electrode overlapping the second via hole near the second via hole and the second sub-electrode not overlapping the second via hole.

The display device may further include a substrate; a first, a second, a third, a fourth, a fifth, a sixth, a seventh, an eighth, and a ninth insulating layers sequentially located on the substrate; a first conductive layer between the second insulating layer and the third insulating layer; a second conductive layer between the third insulating layer and the fourth insulating layer; a third conductive layer between the fifth insulating layer and the sixth insulating layer; a fourth conductive layer between the sixth insulating layer and the seventh insulating layer; a fifth conductive layer between the seventh insulating layer and the eighth insulating layer; and a sixth conductive layer between the eighth insulating layer and the ninth insulating layer. The fourth conductive layer may include the horizontal bridge line, the fifth conductive layer may include the readout line, and the sixth conductive layer may include the first and second vertical bridge lines and the data line.

A display device according to one or more embodiments may include: a first sub-pixel, a second sub-pixel, and a third sub-pixel arranged in a first direction, each of the first to third sub-pixels includes a pixel circuit; a light-sensing pixel including a sensor circuit and is located between the second sub-pixel and the third sub-pixel; a data line electrically connected to each of the second and third sub-pixels; a readout line electrically connected to the light-sensing pixel; a horizontal bridge line extending along the first direction; a first vertical bridge line extending in a second direction and is located in the second sub-pixel; a second vertical bridge line extending in the second direction and is located in the third sub-pixel; and a power wire electrically connected to each of the first to third sub-pixels and which may be configured to receive a first driving voltage. The second vertical bridge line may include a first sub-electrode and a second sub-electrode that are spaced from each other. The first sub-electrode may be electrically connected to the horizontal bridge line and the second sub-electrode may be electrically connected to the power wire.

In a plan view, the second vertical bridge line may be between the readout line and the data line of the third sub-pixel.

The second sub-electrode may be a shielding member that prevents a coupling cap between the readout line and the data line of the third sub-pixel.

An electronic device according to one or more embodiments may include a processor configured to provide input image data to a display device; and the display device configured to display an image based on the input image data. The display device may include a first sub-pixel, a second sub-pixel, and a third sub-pixel arranged along a first direction; a light-sensing pixel between the second sub-pixel and the third sub-pixel; a data line electrically connected to each of the second and third sub-pixels; a readout line electrically connected to the light-sensing pixel; a horizontal bridge line extending along the first direction; a first vertical bridge line extending along a second direction and is located in the second sub-pixel; and a second vertical bridge line extending in the second direction and is located in the third sub-pixel. In a plan view, the second vertical bridge line may be between the readout line and the data line of the third sub-pixel. The second vertical bridge line may include a first sub-electrode and a second sub-electrode that are spaced from each other. The first sub-electrode may be electrically connected to the horizontal bridge line.

The display device may further include a power wire electrically connected to each of the first to third sub-pixels and which may be configured to receive a first driving voltage. The first sub-electrode and the second sub-electrode may be electrically disconnected. The second sub-electrode may be electrically connected to the power wire.

According to one or more embodiments, a vertical bridge line may be between a data line and a readout line. The vertical bridge line may be disconnected (or a portion of the vertical bridge line may be removed) near a connection point where a horizontal bridge line and the vertical bridge line are electrically connected, thereby separating the vertical bridge line into a first sub-electrode and a second sub-electrode. By electrically connecting the second sub-electrode to a power wire supplied with a voltage having a constant voltage level, the second sub-electrode may be utilized as a shielding member preventing a coupling cap that may occur between the data line and the readout line. Accordingly, the reliability of a display device and an electronic device including the same may be improved.

Effects according to embodiments are not limited to the descriptions exemplified above, and more diverse effects are included in the present specification.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

FIG. 1 is a schematic block diagram illustrating a display device according to one or more embodiments.
FIG. 2 is a schematic block diagram illustrating one or more embodiments of the display device of FIG. 1.
FIG. 3 is a schematic plan view illustrating a display device according to one or more embodiments.
FIG. 4 is a schematic enlarged view illustrating a portion EA1 of FIG. 3.
FIG. 5 is a schematic diagram illustrating an example of arrangement of pixel circuits and sensor circuits in a display area of a display panel included in the display device of FIG. 2.
FIG. 6 is a schematic diagram illustrating an example of the display area of the display panel included in the display device of FIG. 2.
FIG. 7 is a schematic diagram illustrating an example of a sub-pixel and a light-sensing pixel included in the display area of FIG. 1.
FIG. 8 is a schematic cross-sectional diagram illustrating one area of a display device according to one or more embodiments.
FIG. 9 is a schematic cross-sectional diagram illustrating a reflection path of light in the display device of FIG. 8.
FIG. 10 is a schematic plan view illustrating sub-pixels and a light-sensing pixel according to one or more embodiments.
FIG. 11 is a schematic plan view illustrating only first, second, fifth, sixth, seventh, eighth, ninth, and eleventh transistors and components included in a first conductive layer in FIG. 10.
FIG. 12 is a schematic plan view illustrating only components included in a second conductive layer in FIG. 10.
FIG. 13 is a schematic plan view illustrating only third, fourth, and tenth transistors and components included in a third conductive layer in FIG. 10.
FIG. 14 is a schematic plan view illustrating only components included in a fourth conductive layer in FIG. 10.
FIG. 15 is a schematic plan view illustrating only components included in a fifth conductive layer in FIG. 10.
FIG. 16 is a schematic plan view illustrating only components included in a sixth conductive layer in FIG. 10.
FIG. 17 is a schematic plan view illustrating only components included in the fourth, fifth, and sixth conductive layers in FIG. 10.
FIG. 18 is a schematic cross-sectional diagram taken along the line I - I' of FIG. 17.
FIG. 19 is a schematic plan view illustrating sub-pixels and light-sensing pixels arranged in a first and a second pixel rows located in one area of a display area of a display device according to one or more embodiments.
FIG. 20 is a schematic diagram illustrating a connection relationship of some wires in one area of a display area of a display device according to one or more embodiments.
FIG. 21 is a schematic plan view illustrating sub-pixels and light-sensing pixels arranged in a first and a second pixel rows located in one area of a display area of a display device according to one or more embodiments.
FIG. 22 is a schematic enlarged view illustrating a portion EA2 of FIG. 21.
FIG. 23 is a schematic cross-sectional diagram taken along the line II - II' of FIG. 22.
FIG. 24 is a schematic plan view illustrating sub-pixels and light-sensing pixels arranged in a first and a second pixel rows located in one area of a display area of a display device according to one or more embodiments.
FIG. 25 is a schematic enlarged view illustrating a portion EA3 of FIG. 24.
FIG. 26 is a schematic block diagram illustrating an electronic device according to one or more embodiments.
FIG. 27 is a schematic diagram illustrating an example of the electronic device of FIG. 26 implemented as a smartphone.
FIG. 28 is a schematic diagram illustrating an example of the electronic device of FIG. 26 implemented as a tablet PC.

### DETAILED DESCRIPTION

The present disclosure may be modified in various ways and may have various forms, and it is intended to illustrate particular embodiments in the drawing and describe them in the detail description. However, this is not intended to limit the present disclosure to a particular embodiment, but should be understood to include all modifications, equivalents, or alternatives included in the technical scope of the present disclosure.

In describing each drawing, similar reference numerals are used for similar components. In the accompanying drawings, the dimensions of the structures are shown enlarged from the actual size for clarity of the present disclosure. Terms such as first and second may be used to describe various components, but the components should not be limited by the terms. The terms are used merely for the purpose of distinguishing one component from another. For example, without departing from the scope of the rights of the present disclosure, a first component may be named as a second component, and similarly, the second component may be named the first component.

In this application, the terms "comprise", "include" or "have" should be understood to designate the existence of the features, numbers, steps, operations, components, parts, or combinations thereof described in the specification, and not to preclude the possibility of the existence or addition of one or more other features or numbers, steps, motions, components, parts, or combinations thereof. Further, when a part such as a layer, a film, an area, or a plate is referred to as being "on" another part, this includes not only the case where the part is "directly on top" of the other part, but also the case where there is another part in between. In addition, in the present specification, when a part such as a layer, a film, an area, or a plate is referred to as being formed on another part, the direction in which the part is formed is not limited to an upward direction, but includes formation in a lateral or downward direction. Conversely, when a part such as a layer, a film, an area, or a plate is referred to as being "below" another part, this includes not only the case where the part is "just below" the other part, but also the case where there is still another part in between.

Hereinafter, referring to the accompanying drawings, embodiments of the present disclosure and other matters necessary for those skilled in the art to easily understand the present disclosure will be explained in detail. In the explanation below, singular expressions also include plural expressions, unless the context clearly indicates that only the singular is included.

For the purposes of the present disclosure, expressions such as "at least one of," "one of," and "selected from," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, XZ, YZ, and ZZ, or any variation thereof. Similarly, the expression such as "at least one of A and/or B" may include A, B, or A and B. As used herein, the term "and/or" includes any and all combinations of one or more of the associated listed items. For example, the expression such as "A and/or B" may include A, B, or A and B. Further, the use of "may" when describing embodiments of the present disclosure refers to "one or more embodiments of the present disclosure".

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, for example, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

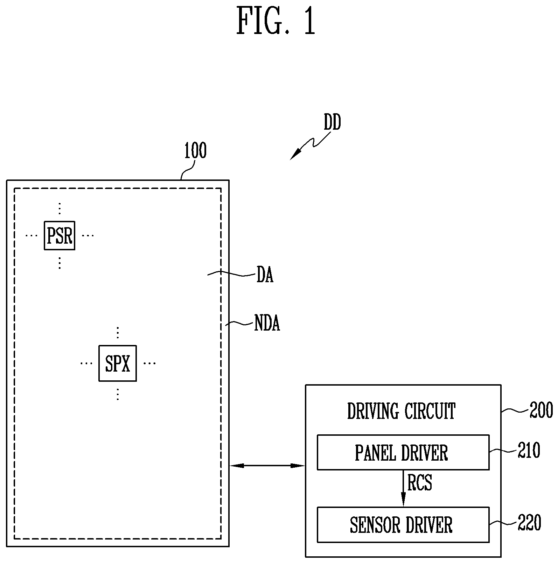

FIG. 1 is a schematic block diagram illustrating a display device DD according to one or more embodiments.

Referring to FIG. 1, the display device DD according to one or more embodiments may include a display panel 100 and a driving circuit 200. In one or more embodiments, the driving circuit 200 may include a panel driver 210 and a sensor driver 220.

The display device DD may be implemented as a self light-emitting display device including a plurality of self light-emitting elements. For example, the display device DD may be an organic light-emitting display device including an organic light-emitting element. However, it is not limited thereto, and the display device DD may be implemented as a display device including an inorganic light-emitting element, a display device including light-emitting elements including a composite of an inorganic material and/or an organic material, or a display device which displays an image using quantum dots.

The display device DD may be a flat display device, a flexible display device, a curved display device, a foldable display device, a bendable display device, and/or a rollable display device. The display device DD may be applied to a transparent display device, a head-mounted display device, a wearable display device, and/or the like.

The display panel 100 may include a display area DA and a non-display area NDA. The display area DA may be an area where sub-pixels SPXs (or pixels) are provided. The sub-pixel SPX may include at least one light-emitting element. For example, the light-emitting element may include a light-emitting layer (e.g., an organic light-emitting layer). A portion emitting light by the light-emitting element may be defined as a light-emitting area. The display device DD may display an image in the display area DA)by activating the sub-pixel SPX in response to image data.

The non-display area NDA may be an area provided around the display area DA along an edge or a periphery of the display area DA. In one or more embodiments, the non-display area NDA may comprehensively refer to the remaining area on the display panel 100 excluding the display area DA. For example, the non-display area NDA may include a wiring area, a pad area, and/or various dummy areas.

The display area DA may include a light-sensing pixel PSR. The light-sensing pixel PSR may be referred to as an optical sensor. The light-sensing pixel PSR may include a light-receiving element which includes a light-receiving layer. Within the display area DA, the light-receiving layer of the light-receiving element may be spaced (e.g., spaced apart) from the light-emitting layer of the light-emitting element.

A plurality of light-sensing pixels PSR may be spaced (e.g., spaced apart) from each other across the entire display area DA. However, the present disclosure is not limited thereto, and only one area of the display area DA may be set as a suitable sensing area (e.g., a predetermined sensing area), and the light-sensing pixels PSR may be provided in the sensing area. Further, at least a part of the non-display area NDA may also be provided with the light-sensing pixels PSR.

The light-sensing pixel PSR may detect light emitted from a light source (e.g., the light-emitting element of the sub-pixel SPX) which is reflected by an external object (e.g., a user's finger). For example, the user's fingerprint may be detected through the light-sensing pixel PSR. Hereinafter, the light-sensing pixel PSR is used for fingerprint detection as an example, but in various embodiments, the light-sensing pixel PSR may detect various biometric information such as iris and veins.

The driving circuit 200 may include the panel driver 210 and the sensor driver 220. The panel driver 210 and the sensor driver 220 may be implemented as independent integrated circuits (ICs). According to one or more embodiments, the driving circuit 200 may be implemented as an integrated circuit. In this case, at least a part of the sensor driver 220 may be included in the panel driver 210 or may operate in conjunction with the panel driver 210.

The panel driver 210 may scan the sub-pixels SPX of the display area DA and supply a data signal corresponding to the image data (or the image) to the sub-pixels SPX. The display panel 100 may display the image corresponding to the data signal.

The panel driver 210 may supply a driving signal for light sensing (e.g., fingerprint sensing) to the sub-pixel SPX. This driving signal may be provided to cause the sub-pixel SPX to emit light and act as a light source for the light-sensing pixel PSR. The panel driver 210 may also supply the driving signal for light sensing and/or another driving signal to the light-sensing pixel PSR. However, the present disclosure is not limited thereto, and driving signals for light sensing may be supplied to the light-sensing pixel PSR by the sensor driver 220.

The sensor driver 220 may detect biometric information such as the user's fingerprint based on a sensing signal received from the light-sensing pixel PSR. According to one or more embodiments, the sensor driver 220 may supply the driving signals to the light-sensing pixel PSR and/or the sub-pixel SPX.

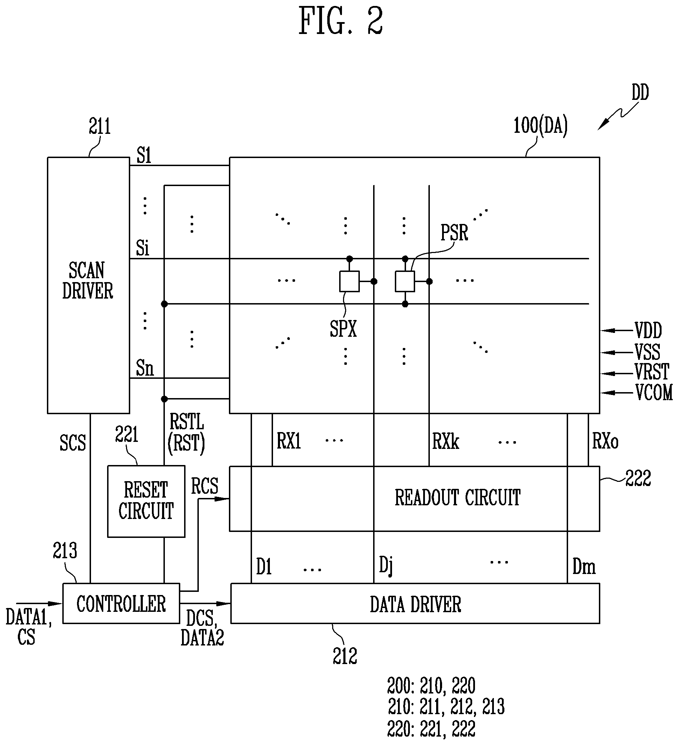

The panel driver 210 may provide a readout control signal RCS (e.g., see FIG. 2) to the sensor driver 220, and the sensor driver 220 may read out (or sample) the sensing signal in conjunction with the panel driver 210 based on the readout control signal RCS. For example, the sensor driver 220 may read out or sample the sensing signal in response to the readout control signal RCS in units of at least one pixel row (or horizontal line).

FIG. 2 is a schematic block diagram illustrating one or more embodiments of the display device DD of FIG. 1.

Referring to FIGS. 1 and 2, the display device DD may include the display panel 100 and the driving circuit 200.

The display panel 100 may include signal wires, sub-pixels SPX, and a light-sensing pixel PSR. The signal wires may include scan lines S1 to Sn, data lines D1 to Dm, readout lines RX1 to RXo, and a reset line RSTL (or a reset control line). Here, n, m, and o may each be natural numbers.

The sub-pixel SPX may be disposed or located in an area (e.g., a pixel area) defined by the scan lines S1 to Sn and the data lines D1 to Dm. The light-sensing pixel PSR may be disposed or located in an area defined by the scan lines S1 to Sn and the readout lines RX1 to RXo. The sub-pixel SPX and the light-sensing pixel PSR may be arranged in a two-dimensional array in the display area DA of the display panel 100, but are not limited thereto.

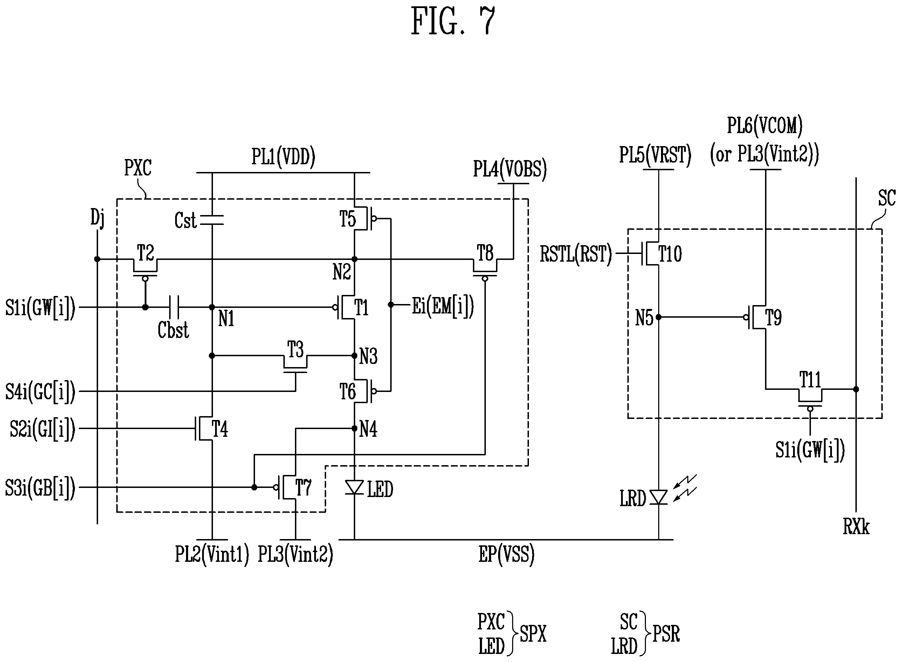

The sub-pixel SPX may be electrically connected to at least one of the scan lines S1 to Sn and at least one of the data lines D1 to Dm. The light-sensing pixel PSR may be electrically connected to one of the scan lines S1 to Sn, one of the readout lines RX1 to RXo, and the reset line RSTL. A connection configuration between the sub-pixel SPX, the light-sensing pixel PSR, and the signal wires will be described below, referring to FIG. 7.

The display panel 100 may be provided with power supply voltages VDD, VSS, VRST, and VCOM required to drive the sub-pixel SPX and the light-sensing pixel PSR. The power supply voltages VDD, VSS, VRST, and VCOM may be supplied from a power supply. The power supply may be implemented with a power management integrated circuit PMIC.

The driving circuit 200 may include a scan driver 211, a data driver 212, a controller 213, a reset circuit 221, and a readout circuit 222. For example, the scan driver 211, the data driver 212, and the controller 213 may be included in the panel driver 210, and the reset circuit 221 and the readout circuit 222 may be included in the sensor driver 220, but are not limited to. According to one or more embodiments, the reset circuit 221 may be included in the panel driver 210.

The scan driver 211 may be electrically connected to the sub-pixel SPX and the light-sensing pixel PSR via the scan lines S1 to Sn. The scan driver 211 may generate scan signals based on a scan control signal SCS and supply the scan signals to the scan lines S1 to Sn. The scan control signal SCS includes an initiation signal, a clock signal, and/or the like, and may be provided from the controller 213 to the scan driver 211. For example, the scan driver 211 may be implemented as a shift register which sequentially shifts a pulsed initiation signal using clock signals to generate and output the scan lines S1 to Sn. The scan driver 211 may selectively drive the sub-pixel SPX and the light-sensing pixel PSR while scanning the display panel 100.

The scan driver 211 may be formed with the sub-pixel SPX of the display panel 100, but is not limited thereto. According to one or more embodiments, the scan driver 211 may be implemented as an integrated circuit (IC).

The sub-pixel SPX selectively driven by the scan driver 211 may emit light at a brightness corresponding to the data signal provided to the corresponding data line from among the data lines D1 to Dm. The light-sensing pixel PSR selectively driven by the scan driver 211 may output an electrical signal (e.g., a sensing signal) corresponding to the detected light to the corresponding readout line. For example, the sub-pixel SPX selectively driven by the i-th scan line Si may emit light with a brightness corresponding to the data signal supplied to the j-th data line Dj (where i and j are natural numbers). For example, the light-sensing pixel PSR selectively driven by the i-th scan line Si may output an electrical signal corresponding to the detected light to the k-th readout line RXk (where k is a natural number).

The data driver 212 may generate the data signal (or data voltage) based on image data DATA2 and the data control signal DCS provided from the controller 213 and supply the data signal to the display panel 100 (or sub-pixel SPX) via the data lines D1 to Dm. The data control signal DCS is a signal which controls operation of the data driver 212 and may include a horizontal initiation signal, a data clock signal, and/or the like. For example, the data driver 212 may include a shift register which shifts the horizontal initiation signal in synchronization with the data clock signal to generate a sampling signal, a latch which latches the image data DATA2 in response to the sampling signal, a digital-to-analog converter (or a decoder) which converts the latched image data (e.g., data in digital form) into an analog data signal, and a buffer (or an amplifier) which outputs the data signal to the corresponding data line (e.g., the j-th data line Dj).

The controller 213 may receive input image data DATA1 and control signal CS from an external device (e.g., a graphics processor, an application processor, a first processor), generate the scan control signal SCS and the data control signal DCS based on the control signal CS, and convert the input image data DATA1 to generate the image data DATA2. The control signal CS may include a vertical synchronous signal, a horizontal synchronous signal, a reference clock signal, and/or the like. The vertical synchronous signal may indicate the start of frame data (i.e., data corresponding to a frame section in which a single frame image is displayed), and the horizontal synchronous signal may indicate the start of a data row (i.e., one data row of a plurality of data rows included in the frame data). The controller 213 may convert the input image data DATA1 into the image data DATA2 with a format which corresponds to pixel arrangement in the display panel 100.

Further, the controller 213 may generate a reset control signal and the readout control signal RCS based on the control signal CS.

The reset circuit 221 may be commonly connected to all light-sensing pixels PSR provided in the display panel 100 through one reset line RSTL. The reset circuit 221 may concurrently (e.g., simultaneously) supply the reset signal RST to all light-sensing pixels PSR in response to the reset control signal. Because the reset signal RST is supplied concurrently (e.g., simultaneously) to all light-sensing pixels PSR, the reset signal RST may be named a global reset signal.

The readout circuit 222 may receive the sensing signal from the light-sensing pixels PSR through the readout lines RX1 to RXo and may perform signal processing on the sensing signal.

For example, the readout circuit 222 may perform a correlated double sampling (CDS) operation to remove noise from the sensing signal provided from the light-sensing pixel PSR. The timing of the correlated double sampling operation of the readout circuit 222 may be determined by the readout control signal RCS. The readout circuit 222 may convert the analog sensing signal into a digital signal (or a digital value). The configuration for the correlated double sampling and analog-to-digital conversion is provided for each of the readout lines RX1 to RXo, and the readout circuit 222 may process the sensing signals provided from the readout lines RX1 to RXo in parallel.

The processed sensing signals, i.e., readout sensing signals, may be transmitted to an external device (e.g., an application processor) as one piece of sensing data (or biometric information), and biometric authentication (e.g., fingerprint authentication) may be performed based on the sensing data. According to one or more embodiments, the read-out sensing signals are supplied to the controller 213, and biometric authentication may also be performed by the controller 213.

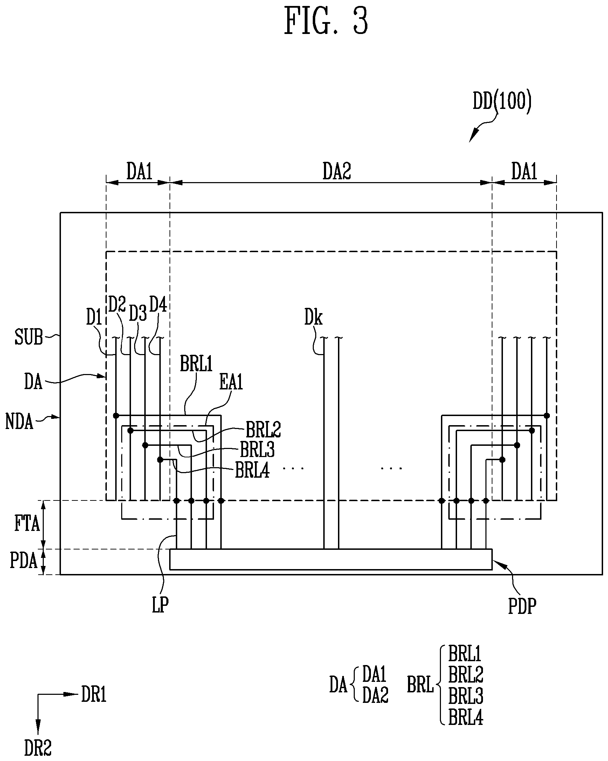

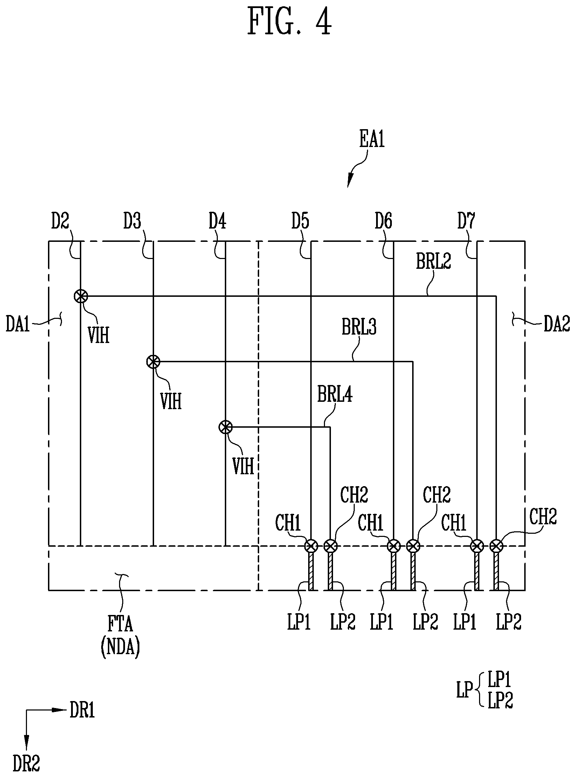

FIG. 3 is a schematic plan view illustrating the display device DD according to one or more embodiments, and FIG. 4 a schematic enlarged view illustrating a portion EA1 of FIG. 3.

Referring to FIGS. 3 and 4, the display device DD (or the display panel 100) may include a substrate SUB in which the display area DA and the non-display area NDA are defined.

The display device DD may be provided in various shapes, but, for example, in the form of a rectangular plate having two pairs of sides which are parallel to each other, and is not limited thereto.

The substrate SUB may include a transparent insulating material to enable light transmission. The substrate SUB may be a rigid or a flexible substrate.

The rigid substrate may, for example, be one of a glass substrate, a quartz substrate, a glass-ceramic substrate, and/or a crystalline glass substrate.

The flexible substrate may be either a film substrate including a polymer organic material and/or a plastic substrate. For example, the flexible substrate may include polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and/or cellulose acetate propionate.

The display area DA may include the first region DA1 and the second area DA2. For example, the display area DA may include the second area DA2 located in the central part and the first area DA1 placed on either side of the second area DA2. The first area DA1 may be an area located in the outer direction rather than the center direction of the display panel 100 centered on the second area DA2, but is not limited thereto.

The sub-pixel (see "SPX" in FIG. 1) and the light-sensing pixel (see "PSR" in FIG. 1) may be arranged in each of the first area DA1 and the second area DA2.

The display device DD may display an image in the first area DA1 and the second area DA2 and detect the user's fingerprint, and/or the like, by selectively driving the sub-pixel SPX and the light-sensing pixel PSR in response to the input image data.

The non-display area NDA may include a fan-out area FTA and a pad area PDA.

The pad area PDA may be located closest to an edge of the non-display area NDA.

The fan-out area FTA may be located adjacent to the display panel DA in the non-display area NDA. For example, the fan-out area FTA may be one area of the non-display area NDA located between the pad area PDA and the display area DA. According to one or more embodiments, the non-display area NDA may include an anti-static circuit area in which an anti-static circuit which is electrically connected to signal wires located in the display area DA is located to prevent static electricity generation.

A wiring part LP may be located in the fan-out area FTA, and a pad part PDP may be located in the pad area PDA.

The wiring part LP may be electrically connected to the sub-pixel SPX and/or the light-sensing pixel PSR and may transmit a suitable signal (e.g., a predetermined signal) applied from the driving circuit (see "200" in FIG. 1) to the signal wires. The wiring part LP may include fan-out lines electrically connecting the driving circuit 200 and the sub-pixels SPX and/or the light-sensing pixel PSR in the fan-out area FTA.

In one or more embodiments, the wiring part LP may be located in the central part of the fan-out area FTA corresponding to the second area DA2 of the display area DA. The wiring part LP may include a first wire LP1 and a second wire LP2. The first wire LP1 may be electrically connected to data lines D5, D6, D7, ..., Dk located in the second area DA2 of the display area DA through a first contact hole CH1. The second wire LP2 may be electrically connected to data lines D1, D2, D3, D4 located in the first area DA1 of the display area DA through a second contact hole CH2 and bridge lines BRL.

In the first area DA1 and the second area DA2, the signal wires may be disposed to which various signals are applied. For example, in the first area DA1 and the second area DA2, the data lines D1 to Dk may be arranged to which the data signal is applied to adjust brightness at each sub-pixel SPX. The data lines D1 to Dk, various signal wires such as power wires and scan lines may be located (or placed) in the first area DA1 and the second area DA2.

The data lines D1 to Dk may be extended along a second direction DR2 in the display area DA. In FIGS. 3 and 4, the first to fourth data lines D1 to D4 may be located in the first area DA1 adjacent to one side (e.g., the left side) of the second area DA2. Four data lines may be located in the first area DA1 adjacent to the other side (e.g., the right side) of the second area DA2. For ease of explanation, the four data lines are shown to be arranged in the first area DA1, but are not limited thereto.

Each of the fifth to k-th data lines D5 to Dk located in the second area DA2 may be electrically connected to the first wire LP1. For example, in the second area DA2, each of the fifth data line D5, the sixth data line D6, and the seventh data line D7 may be electrically connected to the corresponding first wire LP1 through the first contact hole CH1.

The first to fourth data lines D1 to D4 located in the first area DA1 may be electrically connected to the bridge line BRL. The bridge line BRL may be disposed to pass through the display area DA bypassing a portion of the display area DA adjacent to the non-display area NDA.

The first data line D1 may be electrically connected to the first bridge line BRL1, the second data line D2 may be electrically connected to the second bridge line BRL2, the third data line D3 may be electrically connected to the third bridge line BRL3, and the fourth data line D4 may be electrically connected to the fourth bridge line BRL4.

Each of the first to fourth bridge lines BRL1 to BRL4 may be extended from the second area DA2 to the first area DA1. For example, each of the first to fourth bridge lines BRL1 to BRL4 may be routed from the central portion or inner side of the display area DA to the edge (or outer side) of the display area DA. Each of the first to fourth bridge lines BRL1 to BRL4 may be electrically connected to the first to fourth data lines D1 to D4 through a via hole VIH and electrically connected to the corresponding second wire LP2 through the second contact hole CH2.

In FIG. 4, the second bridge line BRL2 may have one end electrically connected to the second wire LP2 through the second contact hole CH2, and the other end electrically connected to the second data line D2 through the via hole VIH. The third bridge line BRL3 may have one end electrically connected to the second wire LP2 through the second contact hole CH2, and the other end electrically connected to the third data line D3 through the via hole VIH. The fourth bridge line BRL4 may have one end electrically connected to the second wire LP2 through the second contact hole CH2, and the other end electrically connected to the fourth data line D4 through the via hole VIH.

Each of the second to fourth bridge lines BRL2 to BRL4 may have one end electrically connected to the second wire LP2 through the second contact hole CH2 between the second display region DA2 and the non-display region NDA, and the other end electrically connected to each of the second to fourth data lines D2 to D4 through the via hole VIH in the first area DA1. In other words, each of the second to fourth bridge lines BRL2 to BRL4 may receive an input signal (e.g., a data signal) from the second wire LP2 and transmit it to each of the second to fourth data lines D2 to D4. The second to fourth bridge lines BRL2 to BRL4 may be disposed on (e.g., at) the same layer as the second wire LP2 or on different layers.

The fifth to seventh data lines D5 to D7 of FIG. 4 may be disposed on (e.g., at) the same layer, and some may be disposed on different layers. For example, the fifth to seventh data lines D5 to D7 may be alternately disposed on different layers.

As described above, by not directly connecting the data line to the wiring part LP in some area of the display area DA (for example, the first area DA1), but instead transmitting the input signal of the wiring part LP to the data line through a bridge line BRL bypassing a part of the display area DA, the area of the non-display area NDA outside the display area DA may be effectively reduced.

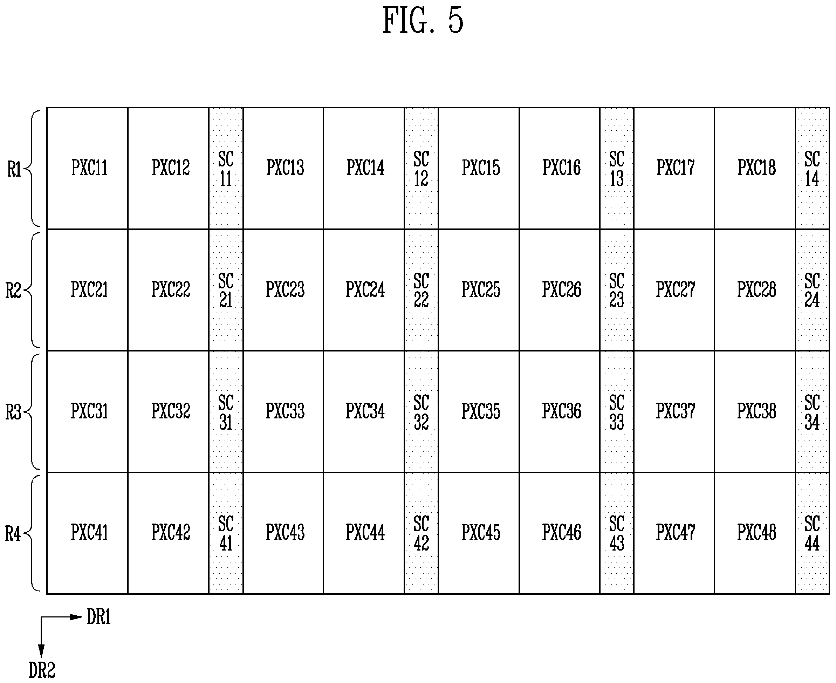

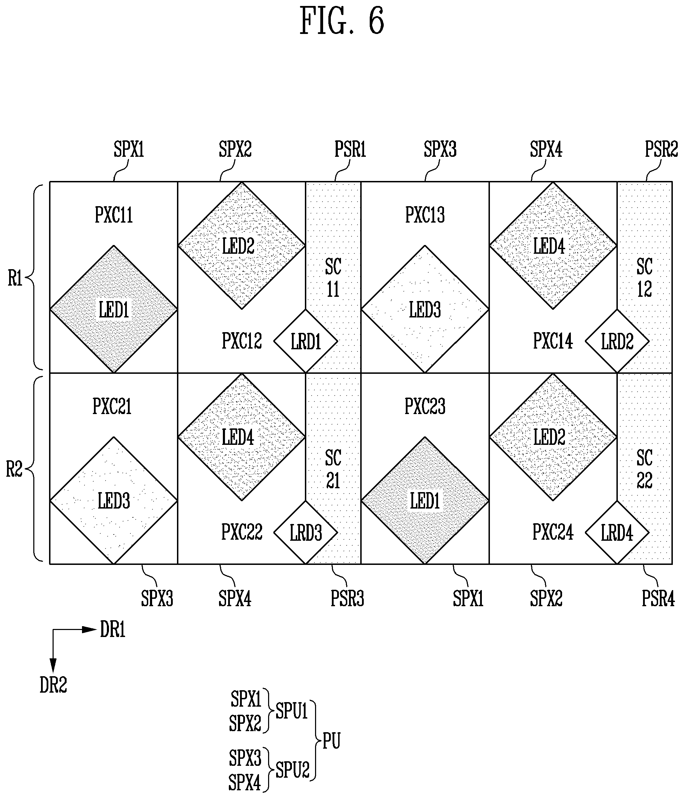

FIG. 5 is a schematic drawing illustrating an example of arrangement of the pixel circuits and the sensor circuits of the display area of the display panel included in the display device of FIG. 2, and FIG. 6 is a schematic diagram illustrating an example of the display area of the display panel included in the display device of FIG. 2.

Referring to FIGS. 1 - 6, the sub-pixels SPX1 to SPX4 and a plurality of light-sensing sensors PSR1 to PSR4 may be located in the display area DA of the display panel 100.

The display area DA may be divided into pixel rows R1 to R4. Each of the pixel rows R1 to R4 extends in a first direction DR1 and may be arranged along the second direction DR2. Each of the pixel rows R1 to R4 may include sub-pixels SPX1 to SPX4. Each of the sub-pixels SPX1 to SPX4 may include one of the pixel circuits PXC11 to PXC48 and one of the light-emitting elements LED1 to LED4.

In one or more embodiments, the first sub-pixel SPX1, the second sub-pixel SPX2, and the third sub-pixel SPX3 may emit light of a first color, light of a second color, and light of a third color, respectively. The light of the first color, the light of the second color, and the light of the third color may be of lights of different colors. Each of the light of the first color, the light of the second color, and the light of the third color may be one of red light, green light, and/or blue light. The first light-emitting element LED1 emitting light of the first color may be located in the first sub-pixel SPX1, the second light-emitting element LED2 emitting light of the second color may be located in the second sub-pixel SPX2, the third light-emitting element LED3 emitting light of the third color may be located in the third sub-pixel SPX3, and the fourth light-emitting element LED4 emitting light of the second color may be located in the fourth sub-pixel SPX4. The second light-emitting element LED2 and the fourth light-emitting element LED4 may emit light of the same color.

In FIG. 6, each of the light-emitting elements LED1 to LED4 may be understood as a light-emitting area corresponding to a light-emitting layer. However, this is for the convenience of explanation, and the color of light emitted by each of the light-emitting elements LED1 to LED4, the position, area, and shape of each of the light-emitting elements LED1 to LED4, and/or the like are not limited thereto.

In one or more embodiments, in each of the odd-numbered pixel rows including the first pixel row R1 (or a first horizontal line) and the third pixel row R3 (or a third horizontal line), the sub-pixels SPX1 to SPX4 may be arranged in the order of the first sub-pixel SPX1 emitting red light, the second sub-pixel SPX2 emitting green light, the third sub-pixel SPX3 emitting blue light, and the fourth sub-pixel SPX4 emitting green light with respect to the first direction DR1.

In each of the even-numbered pixel rows including the second pixel row R2 (or a second horizontal line) and the fourth pixel row R4 (or a fourth horizontal line), the sub-pixels SPX1 to SPX4 may be arranged in the order of the third sub-pixel SPX3, the fourth sub-pixel SPX4, the first sub-pixel SPX1, and the second sub-pixel SPX2 with respect to the first direction DR1.

In one or more embodiments, the first sub-pixel SPX1 and the second sub-pixel SPX2 may form a first sub-pixel unit SPU1, and the third sub-pixel SPX3 and the fourth sub-pixel SPX4 may form a second sub-pixel unit SPU2. In the odd-numbered pixel rows R1, R3, the first sub-pixel unit SPU1 and the second sub-pixel unit SPU2 may be alternately arranged, and in the even-numbered pixel rows R2, R4, the second sub-pixel unit SPU2 and the first sub-pixel unit SPU1 may be alternately arranged, opposite to the odd-numbered pixel rows R1, R3.

The suitable (e.g., predetermined) first and second sub-pixel units SPU1, SPU2 which are adjacent to each other may be understood as forming a single pixel unit PU. For example, FIG. 6 shows the pixel unit PU of each of the first pixel row R1 and the second pixel row R2. However, the present disclosure is not limited thereto, and arrangement of the sub-pixels SPX1 to SPX4 may be variously changed.

In the first pixel row R1, the pixel circuits PXC11 to PXC18 corresponding to each of the sub-pixels SPX1 to SPX4 of the first pixel row R1 may be arranged along the first direction DR1. In the second pixel row R2, the pixel circuits PXC21 to PXC28 corresponding to each of the sub-pixels SPX1 to SPX4 of the second pixel row R2 may be arranged along the first direction DR1. In the third pixel row R3, the pixel circuits PXC31 to PXC38 corresponding to each of the sub-pixels SPX1 to SPX4 of the third pixel row R3 may be arranged along the first direction DR1. In the fourth pixel row R4, the pixel circuits PXC41 to PXC48 corresponding to each of the sub-pixels SPX1 to SPX4 of the fourth pixel row R4 may be arranged along the first direction DR1.

In FIG. 5, the first, second, third, and fourth pixel circuits PXC11, PXC12, PXC13, PXC14 of the first pixel row R1 may be included in one pixel unit PU, and the fifth, sixth, seventh, and eighth pixel circuits PXC15, PXC16, PXC17, PXC18 of the first pixel row R1 may be included in another pixel unit PU.

Similarly, the first to fourth pixel circuits PXC21 to PXC24 of the second pixel row R2, the fifth to eighth pixel circuits PXC25 to PXC28 of the second pixel row R2, the first to fourth pixel circuits PXC31 to PXC34 of the third pixel row R3, the fifth to eighth pixel circuits PXC35 to PXC38 of the third pixel row R3, the first to fourth pixel circuits PXC41 to PXC44 of the fourth pixel row R4, and the fifth to eighth pixel circuits PXC45 to PXC48 of the fourth pixel row R4 may also be included in each of the different pixel units PU.

In one or more embodiments, each of the pixel rows R1 to R4 may include a light-receiving element LRD1 to LRD4. In FIG. 6, each of the light-receiving elements LRD1 to LRD4 may be understood as a light-receiving area corresponding to each of the light-receiving layers. However, this is for the convenience of explanation, and the location, area, and shape of the light-receiving elements LRD1 to LRD4 may be variously modified.

Each of the light-receiving elements LRD1, LRD2 of the first pixel row R1 may overlap with at least some of the pixel circuits PXC11 to PXC14 of the first pixel row R1 and the sensor circuits SC11, SC12 of the first pixel row R1. Each of the light-receiving elements LRD3, LRD4 of the second pixel row R2 may overlap at least some of the pixel circuits PXC21 to PXC24 of the second pixel row R2 and the sensor circuits SC21, SC22 of the second pixel row R2.

In one or more embodiments, the first light-receiving element LRD1 may overlap at least a part of the first sensor circuit SC11 of the first pixel row R1, and the third light-receiving element LRD3 may overlap at least a part of the first sensor circuit SC21 of the second pixel row R2.

Further, the second light-receiving element LRD2 may overlap at least a part of the second sensor circuit SC12 of the first pixel row R1, and the fourth light-receiving element LRD4 may overlap at least a part of the second sensor circuit SC22 of the second pixel row R2.

The light-receiving elements LRD1 to LRD4 may be formed in the display area DA in the arrangement as shown in FIG. 6, but are not limited thereto.

In one or more embodiments, the sensor circuits SC11 to SC44 may be electrically connected to the corresponding light-receiving element. The first sensor circuit SC11 of the first pixel row R1 may be electrically connected to the first light-receiving element LRD1 to form the first light-sensing pixel PSR1. In other words, the first sensor circuit SC11 and the first light-receiving element LRD1 may form the first light-sensing pixel PSR1. The second sensor circuit SC12 of the first pixel row R1 may be electrically connected to the second light-receiving element LRD2 to form the second light-sensing pixel PSR2. In other words, the second sensor circuit SC12 and the second light-receiving element LRD2 may form the second light-sensing pixel PSR2. The first sensor circuit SC21 of the second pixel row R2 may be electrically connected to the third light-receiving element LRD3 to form the third light-sensing pixel PSR3. In other words, the first sensor circuit SC21 and the third light-receiving element LRD3 may form the third light-sensing pixel PSR3. The second sensor circuit SC22 of the second pixel row R2 may be electrically connected to the fourth light-receiving element LRD4 to form the fourth light-sensing pixel PSR4. In other words, the second sensor circuit SC22 and the fourth light-receiving element LRD4 may form the fourth light-sensing pixel PSR4. However, the present disclosure is not limited thereto, and according to one or more embodiments, only a part of the sensor circuits SC11 to SC44 may be provided, and the part may be connected to a plurality of light-receiving elements.

The first sensor circuit SC11 of the first pixel row R1 may be disposed between the first sub-pixel unit SPU1 and the second sub-pixel unit SPU2 included in the pixel unit PU. For example, the first and second pixel circuits PXC11, PXC12 of the first pixel row R1 may be included in the first sub-pixel unit SPU1, and the third and fourth pixel circuits PXC13, PXC14 of the first pixel row R1 may be included in the second sub-pixel unit SPU2. Therefore, at least two pixel circuits (e.g., PXC13, PXC14) may be arranged between the first sensor circuit SC11 and the second sensor circuit SC12 adjacent to each other in the first pixel row R1.

The second sensor circuit SC12 of the first pixel row R1, the first sensor circuit SC21 of the second pixel row R2, and the second sensor circuit SC22 of the second pixel row R2 may be disposed between the first sub-pixel unit SPU1 and the second sub-pixel unit SPU2, similarly to the first sensor circuit SC11 of the first pixel row R1.

FIG. 7 is a schematic drawing illustrating an example of the sub-pixel SPX and the light-sensing pixel PSR included in the display area of FIG. 1. For convenience of explanation, FIG. 7 shows a sub-pixel SPX located on the i-th horizontal line (or i-th pixel row and connected to the j-th data line Dj.

Referring to FIGS. 1 and 7, the sub-pixel SPX and the light-sensing pixel PSR may be located in the i-th horizontal line.

The sub-pixel SPX may include the light-emitting element LED and the pixel circuit PXC. In one or more embodiments, the pixel circuit PXC may include first, second, third, fourth, fifth, sixth, seventh, and eighth transistors T1, T2, T3, T4, T5, T6, T7, T8, a storage capacitor Cst, and a boost capacitor Cbst.

The first transistor T1 (or a driving transistor) may be electrically connected between a first power wire PL1 and a first electrode (or an anode electrode) of the light-emitting element LED. The first transistor T1 may include a gate electrode which is electrically connected to a first node N1. The first transistor T1 may control the amount of current (or driving current) flowing from the first power wire PL1 to an electrode EP (or the power wire) via the light-emitting element LED based on the voltage of the first node N1. A first power supply voltage VDD is supplied to the first power wire PL1, a second supply voltage VSS is supplied to the electrode EP, and the first power supply voltage VDD may be set to a higher voltage than the second power supply voltage VSS.

The second transistor T2 may be electrically connected between the j-th data line Dj and a second node N2. A gate electrode of the second transistor T2 may be connected to the 1i scan line S1i (or a first scan line). The second transistor T2 may be turned on when a first scan signal GW[i] (e.g., a low-level first scan signal) is supplied to the 1i scan line S1i to electrically connect the j-th data line Dj to the second node N2. When each of the first transistor T1 and the third transistor T3 is in a turn-on state, the second transistor T2 may transmit the data signal from the j-th data line Dj to the second node N2 in response to the first scan signal GW[i].

The third transistor T3 may be electrically connected between the first node N1 and a third node N3. A gate electrode of the third transistor T3 may be electrically connected to the 4i scan line S4i (or the third scan line). The third transistor T3 may be turned on when a fourth scan signal GC[i] is supplied to the 4i scan line S4i.

The fourth transistor T4 may be electrically connected between the first node N1 and a second power wire PL2. A gate electrode of the fourth transistor T4 may be electrically connected to the 2i scan line S2i (or the second scan line). The second power wire PL2 may be provided with a first initialization power supply voltage Vint1. The fourth transistor T4 may be turned on by a second scan signal GI[i] supplied to the 2i scan line S2i. When the fourth transistor T4 is turned on, the first initialization power supply voltage Vint1 may be supplied to the first node N1 (i.e., the gate electrode of the first transistor T1).

The fifth transistor T5 may be electrically connected between the first power wire PL1 and the second node N2. A gate electrode of the fifth transistor T5 may be electrically connected to an i-th light-emitting control line Ei. The sixth transistor T6 may be electrically connected between the third node N3 and the light-emitting element LED (or a fourth node N4). A gate electrode of the sixth transistor T6 may be electrically connected to the i-th light-emitting control line Ei. The fifth transistor T5 and the sixth transistor T6 may be turned off when a light-emitting control signal EM[i] (e.g., a high-level light-emitting control signal EM[i]) is supplied to the i-th light-emitting control line Ei, and may be turned on when a low-level light-emitting control signal EM[i] is supplied to the i-th light-emitting control line Ei.

The seventh transistor T7 may be electrically connected between the first electrode of the light-emitting element LED (i.e., the fourth node N4) and a third power wire PL3. A gate electrode of the seventh transistor T7 may be electrically connected to the 3i scan line S3i. The third power wire PL3 may be supplied with a second initialization power supply voltage Vint2. According to one or more embodiments, the second initialization power supply voltage Vint2 may be different from the first initialization power supply voltage Vint1. The seventh transistor T7 may be turned on by a third scan signal GB[i] supplied to the 3i scan line S3i to supply the second initialization power supply voltage Vint2 to the first electrode of the light-emitting element LED.

The eighth transistor T8 may be electrically connected between the second node N2 and a fourth power wire PL4. A gate electrode of the eighth transistor T8 may be electrically connected to the 3i scan line S3i. The fourth power wire PL4 may be supplied with a bias voltage VOBS. The eighth transistor T8 may be turned on by the third scan signal GB[i] supplied to the 3i scan line S3i to supply the bias voltage VOBS to the second node N2.

The storage capacitor Cst may be connected or formed between the first power wire PL1 and the first node N1.

The boost capacitor Cbst (or a capacitor) may be connected or formed between the gate electrode of the second transistor T2 and the gate electrode of the first transistor T1 (e.g., the first node N1).

The light-sensing pixel PSR may include the sensor circuit SC and the light-receiving element LRD. The sensor circuit SC may include a ninth, a tenth, and an eleventh transistors T9, T10, T11.

The ninth and eleventh transistors T9, T11 may be connected in series between a sixth power wire PL6 and the k-th readout line RXk (where k is a natural number).

The ninth transistor T9 (or a first sensor transistor) may be electrically connected between the sixth power wire PL6 and the eleventh transistor T11. A gate electrode of the ninth transistor T9 may be electrically connected to a fifth node N5 (or a sensor node). The ninth transistor T9 may control the current flowing from the sixth power wire PL6 through the eleventh transistor T11 to the k-th readout line RXk in response to the voltage of the fifth node N5. The sixth power wire PL6 may be supplied with a common voltage VCOM.

According to one or more embodiments, the sixth power wire PL6 may be electrically connected to or integrally formed to the third power wire PL3, and the common voltage VCOM applied to the sixth power wire PL6 may be the same as the second initialization power supply voltage Vint2, but are not limited thereto. According to one or more other embodiments, the sixth power wire PL6 may be electrically connected to or integrally formed to the second power wire PL2, and the common voltage VCOM applied to the sixth power wire PL6 may be the same as the first initialization power supply voltage Vint1.

The eleventh transistor T11 (a "second sensor transistor" or "switching transistor") may be electrically connected between the ninth transistor T9 and the k-th readout line RXk. A gate electrode of the eleventh transistor T11 may be connected to the 1i scan line S1i. In other words, the gate electrode of the eleventh transistor T11 and the gate electrode of the second transistor T2 may share the 1i scan line S1i.

The tenth transistor T10 (or a third sensor transistor) may be electrically connected between the fifth power wire PL5 (or a reference power wire) and the fifth node N5. A gate electrode of the tenth transistor T10 may be electrically connected to the reset line RSTL. The fifth power wire PL5 may be supplied with a reset voltage VRST. The reset voltage VRST may be a direct current DC voltage having a constant level. For example, the reset voltage VRST may be about -7 V, but is not limited thereto.

At least one light-receiving element LRD may be electrically connected between the fifth node N5 and the electrode EP to which the second supply voltage VSS is applied.

The light-receiving element LRD may generate electric charge (or current) based on an incident light. In other words, the light-receiving element LRD may perform the function of photoelectric conversion. For example, the light-receiving element LRD may be implemented as a photodiode.

When the tenth transistor T10 is turned on by the reset signal RST supplied to the reset line RSTL, the reset voltage VRST may be supplied to the fifth node N5. For example, the voltage of the fifth node N5 may be reset by the reset voltage VRST. After the reset voltage VRST is applied to the fifth node N5, the light-receiving element LRD may perform the function of photoelectric conversion.

The voltage of the fifth node N5 may be changed by the operation of the light-receiving element LRD. The voltage of the fifth node N5 (or the charge or current generated by the light-receiving element LRD) may vary depending on the intensity of the light incident on the light-receiving element LRD and the time for which the light is incident (or the time for which the light-receiving element LRD is exposed to light).

When the eleventh transistor T11 is turned on by the first scan signal GW[i] supplied to the first scan line S1i, a detection value (current and/or voltage) generated based on the voltage of the fifth node N5 may flow to the k-th readout line RXk.

In one or more embodiments, each of the pixel circuit PXC and the sensor circuit SC may include a P-type transistor and an N-type transistor. The third transistor T3, the fourth transistor T4, and the tenth transistor T10 may be formed as oxide semiconductor transistors including oxide semiconductors (or second type semiconductors). For example, each of the third transistor T3, the fourth transistor T4, and the tenth transistor T10 may be an N-type oxide semiconductor transistor and may include an oxide semiconductor layer as an active layer, but is not limited thereto.

The remaining transistors (e.g., the first, second, fifth, sixth, seventh, eighth, ninth, and eleventh transistors T1, T2, T5, T6, T7, T8, T9, T11) are formed from polysilicon transistors including silicon semiconductors (or, first type semiconductors) and each of them may include a polysilicon semiconductor layer as an active layer. For example, the active layer may be formed through a low-temperature polysilicon process (e.g., an LTPS process).

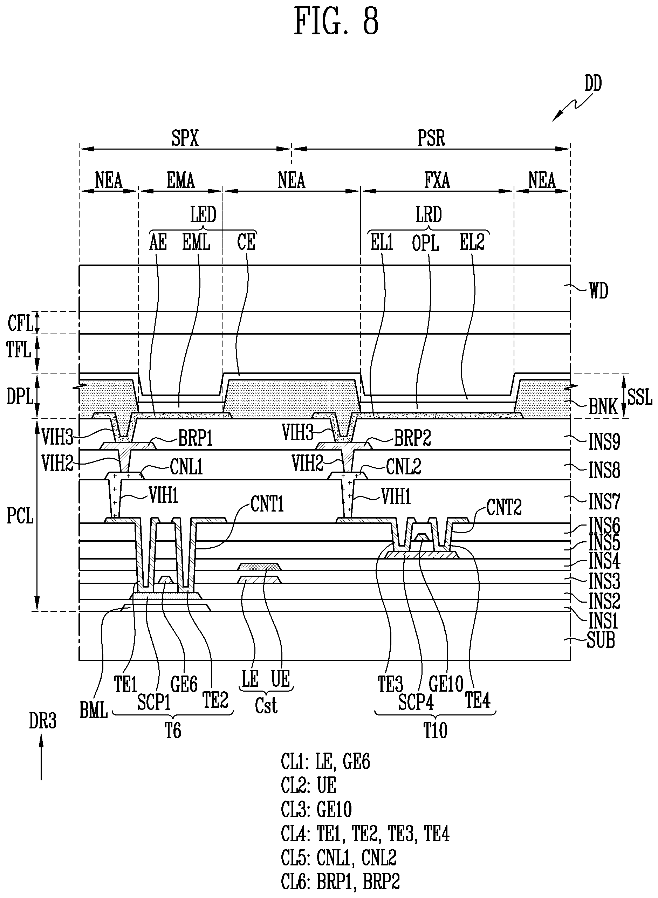

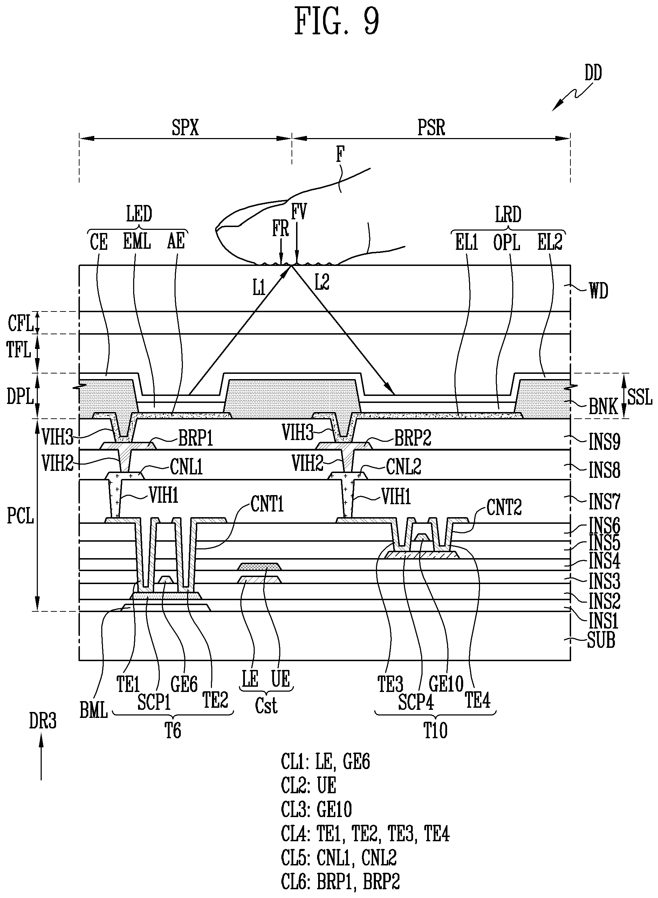

Hereinafter, referring to FIGS. 8 and 9, a stacked structure (or a cross-sectional structure) of a sub-pixel SPX including a light-emitting element LED and a light-sensing pixel PSR including a light-receiving element LRD will be mainly explained.

FIG. 8 is a schematic cross-sectional diagram illustrating an area of the display device DD according to one or more embodiments, and FIG. 9 is a schematic cross-sectional diagram illustrating a reflection path of light in the display device DD of FIG. 8.

In FIGS. 8 and 9, a cross-section of a portion corresponding to the sixth transistor T6 from among the first to eighth transistors T1 to T8 shown in FIG. 7 and a cross-section of a portion corresponding to the tenth transistor T10 from among the ninth to eleventh transistors T9 to T11 are illustrated.

Referring to FIGS. 1 - 9, the display device DD may include the sub-pixel SPX and the light-sensing pixel PSR provided in one region of the substrate SUB.

On the substrate SUB, the pixel circuit layer PCL of the sub-pixel SPX and the pixel circuit layer PCL of the light-sensing pixel PSR may be disposed. At least one insulating layer may be located in the pixel circuit layer PCL. The insulating layer may include a first insulating layer INS1, a second insulating layer INS2, a third insulating layer INS3, a fourth insulating layer INS4, a fifth insulating layer INS5, a sixth insulating layer INS6, a seventh insulating layer INS7, an eighth insulating layer INS8, and a ninth insulating layer INS9 sequentially stacked on the substrate SUB along a third direction DR3.

The first insulating layer INS1 (or a buffer layer) may be disposed on the substrate SUB. The first insulating layer INS1 may prevent diffusion of impurities into the sixth transistor T6 and the tenth transistor T10. The first insulating layer INS1 may be an inorganic film including an inorganic material (or substance). The first insulating layer INS1 may include silicon nitride (SiNₓ), silicon oxide (SiOₓ), silicon oxynitride (SiOₓN_{y}), and/or aluminum oxide (AlOₓ). The first insulating layer INS1 may be provided as a single layer, but may also be provided as multiple layers, including at least two layers. The first insulating layer INS1 may be omitted depending on the material and process conditions of the substrate.

The second insulating layer INS2 (or a first gate insulating layer) may be disposed on the first insulating layer INS1. The second insulating layer INS2 may include the same material as the first insulating layer INS1 or may include a material suitable (or selected) from the example materials discussed as constituent materials of the first insulating layer INS1. For example, the second insulating layer INS2 may be an inorganic film including an inorganic material.

The third insulating layer INS3 (or a second gate insulating layer) may be disposed on the second insulating layer INS2. The third insulating layer INS3 may include the same material as the first insulating layer INS1 or may include one or more materials suitable (or selected) from the example materials discussed as constituent materials of the first insulating layer INS1.

The fourth insulating layer INS4 (or a first interlayer insulating layer) may be disposed on the third insulating layer INS3. The fourth insulating layer INS4 may be an inorganic film including an inorganic material or an organic film including an organic material.

The fifth insulating layer INS5 (or a third gate insulating layer) may be disposed on the fourth insulating layer INS4. The fifth insulating layer INS5 may be an inorganic film including an inorganic material or an organic film including an organic material.

The sixth insulating layer INS6 (or a second interlayer insulating layer) may be disposed on the fifth insulating layer INS5. The sixth insulating layer INS6 may be an inorganic film including an inorganic material or an organic film including an organic material.

The seventh insulating layer INS7 (or a first via layer) may be disposed on the sixth insulating layer INS6. The seventh insulating layer INS7 may be an inorganic film including an inorganic material or an organic film including an organic material. The inorganic film may include, for example, silicon oxide (SiOₓ), silicon nitride (SiNₓ), silicon oxynitride (SiOₓN_{y}), and/or aluminum oxide (AlOₓ). The organic film may include, for example, polyacrylates resin, epoxy resin, phenolic resin, polyamides resin, polyimides resin, unsaturated polyesters resin, poly-phenylene ethers resin, poly-phenylene sulfides resin, and/or benzocyclobutene resin. In one or more embodiments, the seventh insulating layer INS7 may be an organic film.

The eighth insulating layer INS8 (or a second via layer) may be disposed on the seventh insulating layer INS7. The eighth insulating layer INS8 may include the same material as the seventh insulating layer INS7 or may include one or more materials suitable (or selected) from the example materials discussed as constituent materials of the seventh insulating layer INS7. For example, the eighth insulating layer INS8 may be an organic film including an organic material.

The ninth insulating layer INS9 (or a third via layer) may be disposed on the eighth insulating layer INS8. The ninth insulating layer INS9 may include the same material as the seventh insulating layer INS7 or may include one or more materials suitable (or selected) from the example materials discussed as constituent materials of the seventh insulating layer INS7. For example, the ninth insulating layer INS9 may be an organic film including an organic material.

The pixel circuit layer PCL may include at least one conductive layer disposed between the above-described insulating layers. For example, the conductive layers may include a first conductive layer CL1 disposed between the second insulating layer INS2 and the third insulating layer INS3, a second conductive layer CL2 disposed between the third insulating layer INS3 and the fourth insulating layer INS4, a third conductive layer CL3 disposed between the fifth insulating layer INS5 and the sixth insulating layer INS6, a fourth conductive layer CL4 disposed between the sixth insulating layer INS6 and the seventh insulating layer INS7, a fifth conductive layer CL5 disposed between the seventh insulating layer INS7 and the eighth insulating layer INS8, and a sixth conductive layer CL6 disposed between the eighth insulating layer INS8 and the ninth insulating layer INS9. The insulating layers and conductive layers are not limited to the above-described embodiments, and according to one or more embodiments, other insulating layers and other conductive layers other than the insulating layers and the conductive layers may be arranged in the pixel circuit layer PCL.

In one or more embodiments, a first semiconductor layer may be disposed between the first insulating layer INS1 and the second insulating layer INS2. The first semiconductor layer may include a silicon semiconductor. For example, the silicon semiconductor may include amorphous silicon, polycrystalline silicon, and/or the like. The first semiconductor layer may include, but is not limited to, low-temperature polysilicon. The first semiconductor layer may include a first semiconductor region having high conductivity and a second semiconductor region having low conductivity. The first semiconductor region may be doped with an N-type dopant or a P-type dopant. A P-type transistor may include a doped region doped with a P-type dopant, and an N-type transistor may include a doped region doped with an N-type dopant. The second semiconductor region may be an un-doped region or a region doped at a lower concentration than the first semiconductor region. The conductivity of the first semiconductor region may be greater than that of the second semiconductor region. The first semiconductor region may substantially serve as an electrode or a signal wire. The second semiconductor region may substantially correspond to an active pattern (or a channel region) of the transistor. A portion of the first semiconductor layer may be an active pattern region of the transistor, another portion of the first semiconductor layer may be a source/drain region (or a source/drain electrode) of the transistor, and still another portion of the first semiconductor layer may be a connection electrode or a connection signal wire, but are not limited thereto.

In one or more embodiments, a second semiconductor layer may be disposed between the fourth insulating layer INS4 and the fifth insulating layer INS5. The second semiconductor layer may include an oxide semiconductor. The oxide semiconductor may include a plurality of regions which are distinguished by whether or not a metal oxide has been reduced. A region where the metal oxide is reduced (hereinafter referred to as a "reduction region") may have greater conductivity than a region where it is not reduced (hereinafter referred to as a "non-reduction region"). The reduction region may be substantially utilized as the source/drain region of the transistor or as the signal wire. The non-reduction region may substantially correspond to the active pattern (or channel region) of the transistor. A part of the second semiconductor layer may be the active pattern of the transistor, another part may be the source/drain region (or source/drain electrode) of the transistor, and still another part may be a signaling region, but are not limited thereto.

In the pixel circuit layer PCL, the sixth transistor T6 and the tenth transistor T10 may be located.

The sixth transistor T6 may include the gate electrode GE6, hereinafter referred to as a "sixth gate electrode"), a first semiconductor pattern SCP1, a first terminal TE1, and a second terminal TE2. The tenth transistor T10 may include the gate electrode GE10, (hereinafter referred to as a "tenth gate electrode"), a fourth semiconductor pattern SCP4, a third terminal TE3, and a fourth terminal TE4.

The first semiconductor pattern SCP1 is disposed on the first insulating layer INS1 and may include the first semiconductor layer. The first semiconductor pattern SCP1 may include a channel region, a first contact region, which connects to one end of the channel region, and a second contact region, which connects to the other end of the channel region. The second insulating layer INS2 may be disposed on the first semiconductor pattern SCP1.

The sixth gate electrode GE6 is disposed on the second insulating layer INS2 and may include the first conductive layer CL1. The first conductive layer CL1 may be formed as a single layer or multiple layers made of molybdenum, copper, chromium, gold, silver, titanium, nickel, neodymium, indium, tin, and/or oxides and/or alloys thereof. For example, the first conductive layer CL1 may be formed of, but is not limited to, multiple layers of titanium, copper, and/or indium tin oxide sequentially or repeatedly stacked. The sixth gate electrode GE6 may overlap with one region of the first semiconductor pattern SCP1. The region of the first semiconductor pattern SCP1 overlapping with the sixth gate electrode GE6 may be a channel region of the sixth transistor T6. The third insulating layer INS3 may be disposed on the sixth gate electrode GE6.

The first terminal TE1 and the second terminal TE2 may be disposed on the sixth insulating layer INS6. The first terminal TE1 and the second terminal TE2 may be formed of the fourth conductive layer CL4. The fourth conductive layer CL4 may be formed as a single layer or multiple layers made of molybdenum, copper, aluminum, chromium, gold, silver, titanium, nickel, neodymium, indium, tin, and/or oxides and/or alloys thereof.

The first terminal TE1 may be electrically connected to the second contact region of the first semiconductor pattern SCP1 through a first contact CNT1 which penetrates the second insulating layer INS2, the third insulating layer INS3, the fourth insulating layer INS4, the fifth insulating layer INS5, and the sixth insulating layer INS6. The first terminal TE1 may be electrically connected to an anode electrode AE of the light-emitting element LED. The second terminal TE2 may be electrically connected to the first contact region of the first semiconductor pattern SCP1 through another first contact CNT1 which penetrates the second insulating layer INS2, the third insulating layer INS3, the fourth insulating layer INS4, the fifth insulating layer INS5, and the sixth insulating layer INS6.

The seventh insulating layer INS7 may be disposed on the first terminal TE1 and the second terminal TE2.

The fourth semiconductor pattern SCP4 may be disposed on the fourth insulating layer INS4. The fourth semiconductor pattern SCP4 may be formed of the second semiconductor layer. The fourth semiconductor pattern SCP4 may include a channel region, a first contact region, which connects to one end of the channel region, and a second contact region, which connects to the other end of the channel region. The fifth insulating layer INS5 may be disposed on the fourth semiconductor pattern SCP4.

The tenth gate electrode GE10 may be disposed on the fifth insulating layer INS5. The tenth gate electrode GE10 may be formed of the third conductive layer CL3. The third conductive layer CL3 may include the same material as the first conductive layer CL1 or the fourth conductive layer CL4, or may include a suitable (or selected) material from the example materials discussed as constituent materials of the first conductive layer CL1 or the fourth conductive layer CL4. The tenth gate electrode GE10 may overlap with one region of the fourth semiconductor pattern SCP4. The region of the fourth semiconductor pattern SCP4 which overlaps with the tenth gate electrode GE10 may be the channel region of the tenth transistor T10.

The sixth insulating layer INS6 may be disposed on the tenth gate electrode GE10.

The third terminal TE3 and the fourth terminal TE4 may be disposed on the sixth insulating layer INS6. The third terminal TE3 and the fourth terminal TE4 may be formed of the fourth conductive layer CL4.

The third terminal TE3 may be electrically connected to the first contact region of the fourth semiconductor pattern SCP4 through a second contact CNT2 penetrating the fifth insulating layer INS5 and the sixth insulating layer INS6. The fourth terminal TE4 may be electrically connected to the second contact region of the fourth semiconductor pattern SCP4 through the second contact CNT2 penetrating the fifth insulating layer INS5 and the sixth insulating layer INS6. The third terminal TE3 and the fourth terminal TE4 may be spaced (e.g., spaced apart) from each other on the sixth insulating layer INS6. The seventh insulating layer INS7 may be disposed on the third terminal TE3 and the fourth terminal TE4.

The pixel circuit layer PCL may further include a bottom metal pattern BML disposed on the substrate SUB. The bottom metal pattern BML may overlap with the sixth transistor T6 and, according to one or more embodiments, may be electrically connected to the sixth transistor T6 to stabilize the channel region of the sixth transistor T6.

In the pixel circuit layer PCL, a storage capacitor Cst may be located. The storage capacitor Cst may include a lower electrode LE and an upper electrode UE.

The lower electrode LE may be disposed on the second insulating layer INS2. The lower electrode LE may be formed of the first conductive layer CL1 and may be provided in (e.g., at) the same layer as the sixth gate electrode GE6, but is not limited thereto. The third insulating layer INS3 may be disposed on the lower electrode LE.

The upper electrode UE may be disposed on the third insulating layer INS3. The upper electrode UE may be formed of the second conductive layer CL2, but is not limited thereto. The second conductive layer CL2 may include the same material as the first conductive layer CL1 or the fourth conductive layer CL4, or may include one or more materials suitable (or selected) from the example materials discussed as constituent materials of the first conductive layer CL1 or the fourth conductive layer CL4. The upper electrode UE may form capacitance by overlapping the lower electrode LE with the third insulating layer INS3 therebetween.

A first connection wire CNL1, a second connection wire CNL2, a first bridge pattern BRP1, and a second bridge pattern BRP2 may be arranged in the pixel circuit layer PCL.

The first connection wire CNL1 and the second connection wire CNL2 may be disposed on the seventh insulating layer INS7. The first connection wire CNL1 and the second connection wire CNL2 may be formed of the fifth conductive layer CL5. The fifth conductive layer CL5 may include the same material as the first conductive layer CL1 or the fourth conductive layer CL4, or may include one or more materials suitable (or selected) from the example materials discussed as constituent materials of the first conductive layer CL1 or the fourth conductive layer CL4. The first connection wire CNL1 may be electrically connected to the first terminal TE1 of the sixth transistor T6 through a first via hole VIH1 that penetrates the seventh insulating layer INS7. The second connection wire CNL2 may be electrically connected to the third terminal TE3 of the tenth transistor T10 through another first via hole VIH1 that penetrates the seventh insulating layer INS7. The eighth insulating layer INS8 may be disposed on the first connection wire CNL1 and the second connection wire CNL2.

The first bridge pattern BRP1 and the second bridge pattern BRP2 may be disposed on the eighth insulating layer INS8. The first bridge pattern BRP1 and the second bridge pattern BRP2 may be formed of the sixth conductive layer CL6. The sixth conductive layer CL6 may include the same material as the first conductive layer CL1 or the fourth conductive layer CL4, or may include one or more materials suitable (or selected) from the example materials discussed as constituent materials of the first conductive layer CL1 or the fourth conductive layer CL4. The first bridge pattern BRP1 may be electrically connected to the first connection wire CNL1 through a second via hole VIH2 that penetrates the eighth insulating layer INS8. The second bridge pattern BRP2 may be electrically connected to the second connection wire CNL2 through another second via hole VIH2 that penetrates the eighth insulating layer INS8. On the first and second bridge patterns BRP1, BRP2, the ninth insulating layer INS9 may be disposed.

A display element layer DPL may be disposed on the pixel circuit layer PCL of the sub-pixel SPX, and a sensor layer SSL may be disposed on the pixel circuit layer PCL of the light-sensing pixel PSR.

In the display element layer DPL, the light-emitting element LED and a bank BNK may be located. The light-emitting element LED may include an anode electrode AE (or a pixel electrode), a light-emitting layer EML, and a cathode electrode CE (or a common electrode). The light-emitting element LED may be electrically connected to the sixth transistor T6 through the first bridge pattern BRP1 and the first connection wire CNL1. The light-emitting layer EML may include a hole transport layer, an organic material layer (or a photogenic layer), an electron transport layer, and/or the like.

A light-receiving element LRD and a bank BNK may be located in the sensor layer SSL. The light-receiving element LRD may be an optical fingerprint sensor. The light-receiving element LRD may recognize a fingerprint by sensing light reflected by ridges FR of a finger F and a valley FV between the ridges FR. For example, when the user's finger F touches a window WD, first light L1 output from the light-emitting element LED (or a light-emitting layer EML) is reflected by the ridge FR and/or valley FV of the finger F, and reflected second light L2 may reach the light-receiving element LRD (or a light-receiving layer OPL) of the sensor layer SSL. The light-receiving element LRD may recognize the pattern of the user's fingerprint by distinguishing between the second light L2 reflected from the ridge FR of the finger F and the second light L2 reflected from the valley FV of the finger F. The light-receiving element LRD may be electrically connected to the tenth transistor T10. A light-receiving element LRD may include a first electrode EL1 (or a first sensor electrode), a light-receiving layer OPL (or a photoelectric conversion layer), and a second electrode EL2 (or a second sensor electrode).

The anode electrode AE and the first electrode EL1 may be disposed on the ninth insulating layer INS9. The anode electrode AE and the first electrode EL1 may include, but are not limited to, metal layers such as silver, magnesium, aluminum, platinum, palladium, gold, nickel, neodymium, iridium, chromium, and/or their alloys, and/or indium tin oxide (ITO), indium zinc oxide (IZO), zinc oxide (ZnO), and/or indium tin zinc oxide (ITZO). The anode electrode AE may be electrically connected to the first bridge pattern BRP1 through a third via hole VIH3 that penetrates the ninth insulating layer INS9. The first electrode EL1 may be electrically connected to the second bridge pattern BRP2 through another third via hole VIH3 that penetrates the ninth insulating layer INS9.

The anode electrode AE and the first electrode EL1 may be formed concurrently (e.g., simultaneously) or sequentially through patterning using a mask.

The bank BNK may be a pixel defining film that defines (or partitions) an light-emitting area EMA of the sub-pixel SPX and a light-receiving area FXA of the light-sensing pixel PSR. The bank BNK may be an organic film including an organic material (or substance). The organic material may include acryl resin, epoxy resin, phenolic resin, polyamide resin, and/or polyimide resin. The bank BNK may be disposed on the ninth insulating layer INS9 in a non-light-emitting area NEA of the sub-pixel SPX and the light-sensing pixel PSR.

According to one or more embodiments, the bank BNK may include a light-absorbing material, or may be coated with a light-absorbing agent to absorb light coming from the outside. For example, the bank BNK may include, but is not limited to, a carbon-based black pigment. The bank BNK may also include an opaque metal material such as chromium, molybdenum, alloys of molybdenum and titanium, tungsten, vanadium, niobium, tantalum, manganese, cobalt, and/or nickel, which have high light absorption. The bank BNK may include openings corresponding to the light-emitting area EMA and the light-receiving area FXA.

The light-emitting layer EML may be disposed on the anode electrode AE. The light-emitting layer EML may include an organic light-emitting layer. Depending on the organic material included in the light-emitting layer EML, the light-emitting layer EML may emit light such as red, green, and/or blue light, but is not limited thereto.

The light-receiving layer OPL may be disposed on the first electrode EL1. The light-receiving layer OPL may detect the intensity of light by emitting electrons in response to light of a specific wavelength band.

The light-receiving layer OPL may include a low molecular weight organic material (or substance). For example, the light-receiving layer OPL may be formed of a phthalocyanines compound including one or more metals selected from the group consisting of copper (Cu), iron (Fe), nickel (Ni), cobalt (Co), manganese (Mn), aluminum (Al), palladium (Pd), tin (Sn), indium (In), lead (Pb), titanium (Ti), rubidium (Rb), vanadium (V), gallium (Ga), terbium (Tb), cerium (Ce), lanthanum (La), and zinc (Zn).

Alternatively, the low molecular weight organic material included in the light-receiving layer OPL may include two layers (bi-layers) including a layer including a phthalocyanines compound including one or more metals selected from the group consisting of copper (Cu), iron (Fe), nickel (Ni), cobalt (Co), manganese (Mn), aluminum (Al), palladium (Pd), tin (Sn), indium (In), lead (Pb), titanium (Ti), rubidium (Rb), vanadium (V), gallium (Ga), terbium (Tb), cerium (Ce), lanthanum (La), and zinc (Zn) and a layer including C60, or may include a single mixing layer in which the phthalocyanines compound and C60 are mixed. However, the present disclosure is not limited to the embodiment described above, and according to one or more embodiments, the light-receiving layer OPL may include a polymer organic layer.

The cathode electrode CE may be disposed on the light-emitting layer EML and the second electrode EL2 may be disposed on the light-receiving layer OPL. The cathode electrode CE and the second electrode EL2 may be a common electrode formed integrally in the display area DA. The second power supply voltage VSS may be supplied to the cathode electrode CE and the second electrode EL2.

The cathode electrode CE and the second electrode EL2 may include a metal layer such as Ag, Mg, Al, Pt, Pd, Au, Ni, Nd, Ir, and/or Cr, and/or a transparent conductive layer such as ITO, IZO, ZnO, and/or ITZO. In one or more embodiments, the cathode electrode CE and the second electrode EL2 may be formed of multiple layers, including a double layer or more including a metal thin film layer, and may be formed of a triple layer of ITO/Ag/ITO, for example.

A thin film encapsulation layer TFE may be formed on the entire surface of the cathode electrode CE and the second electrode EL2.

The thin film encapsulation layer TFE may be formed of a single layer, but may also be formed of multiple layers. The thin film encapsulation layer TFE may include a plurality of insulating layers covering the light-emitting element LED and the light-receiving element LRD. Specifically, the thin film encapsulation layer TFE may include at least one inorganic film and/or at least one organic film. For example, the thin film encapsulation layer TFE may have a stacked structure in which inorganic and organic films are alternately stacked.

A color filter layer CFL may be disposed on the thin film encapsulation layer TFE. The color filter layer CFL may include a shading pattern and a color filter. The shading pattern may be disposed on the thin film encapsulation layer TFE to correspond to the light-emitting area EMA of the sub-pixel SPX and the non-light-emitting area NEA around (e.g., surrounding) the light-receiving area FXA of the light-sensing pixel PSR, and the color filter may be disposed on the thin film encapsulated layer TFE to correspond to the light-emitting area EMA and the light-receiving area FXA. The color filter layer CFL described above may also be used as an anti-reflective layer to block external light reflection.

The window WD may be disposed on the color filter layer CFL.

The window WD may protect an exposed surface of the display device DD (or the display panel (see "100" in FIG. 1)). The window WD may protect the display device DD from external shocks and provide the user with an input surface and/or display surface. The window WD (or a cover glass) may have a multi-layered structure selected from a glass substrate, a plastic film, and/or a plastic substrate. This multi-layered structure may be formed through a continuous process or an adhesive process using an adhesive layer. The window WD may be flexible in whole or in part.

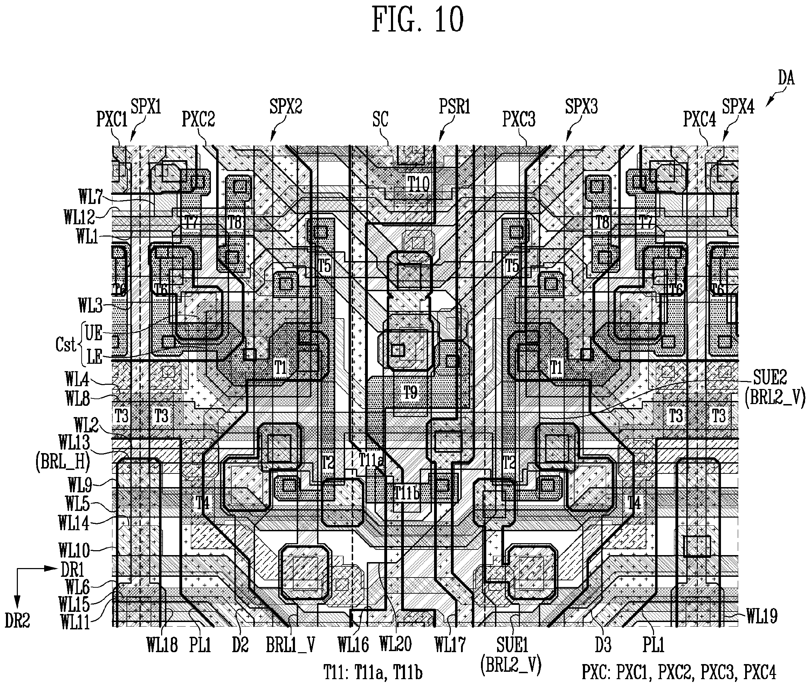

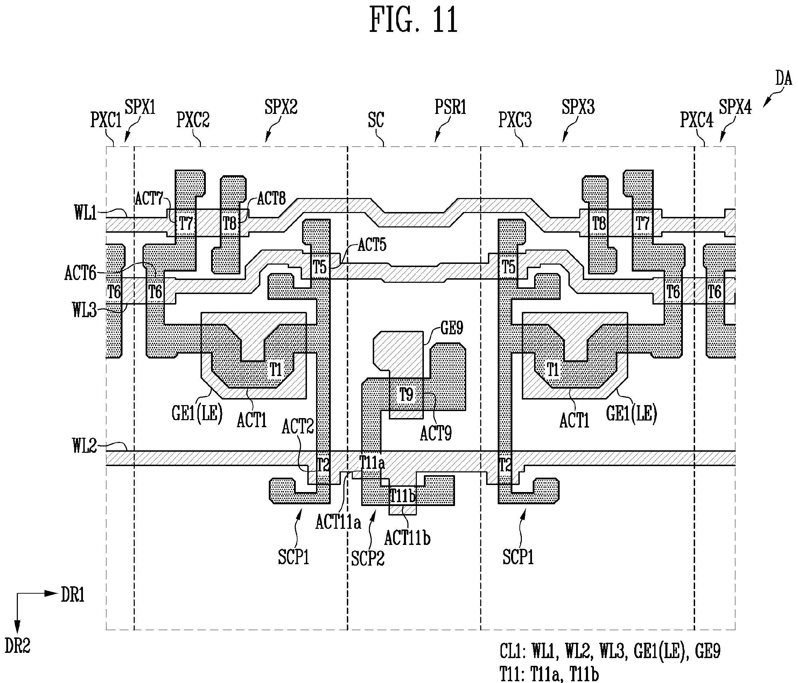

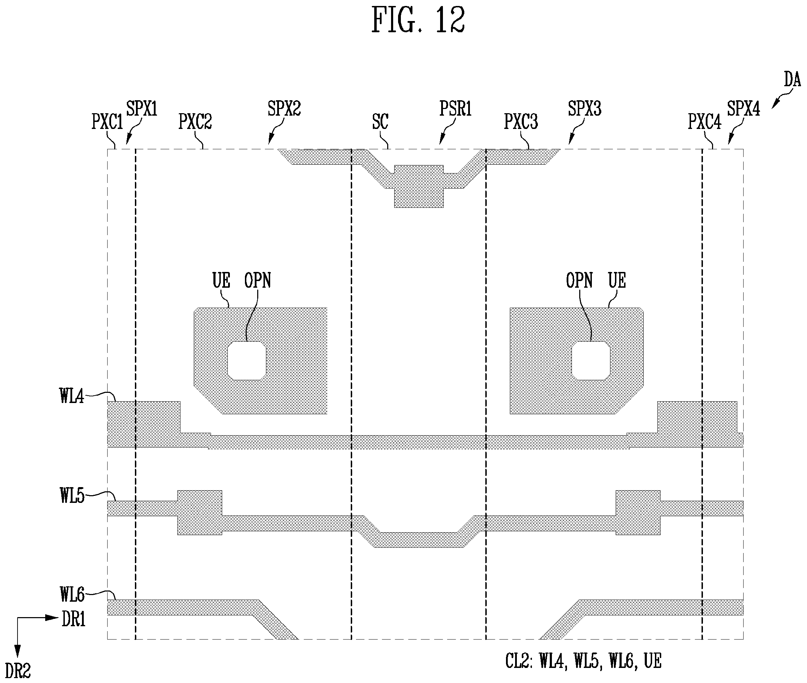

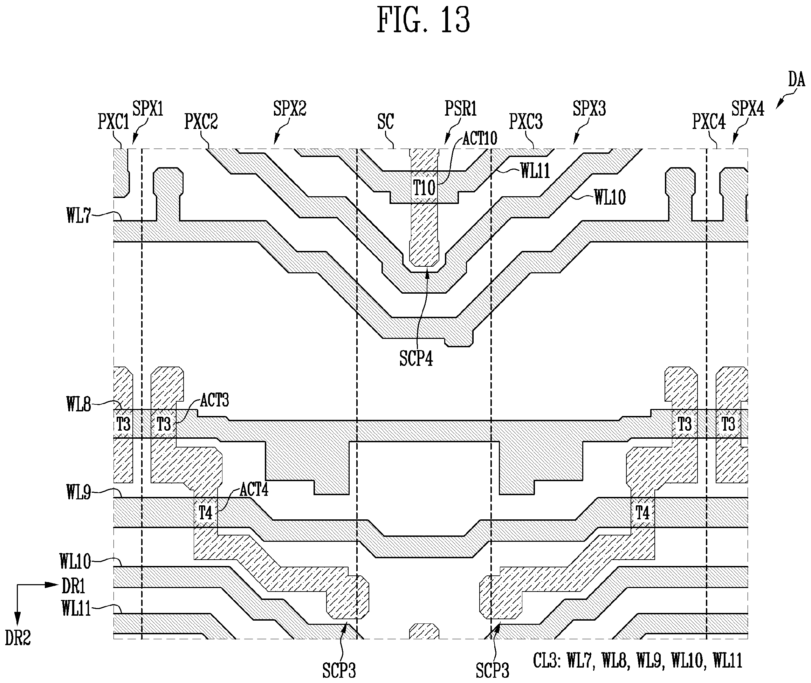

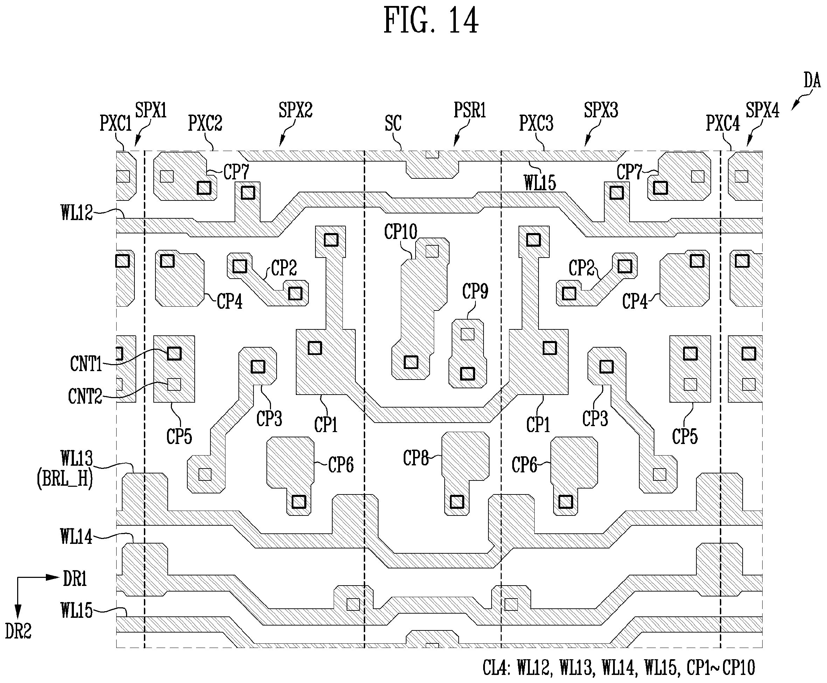

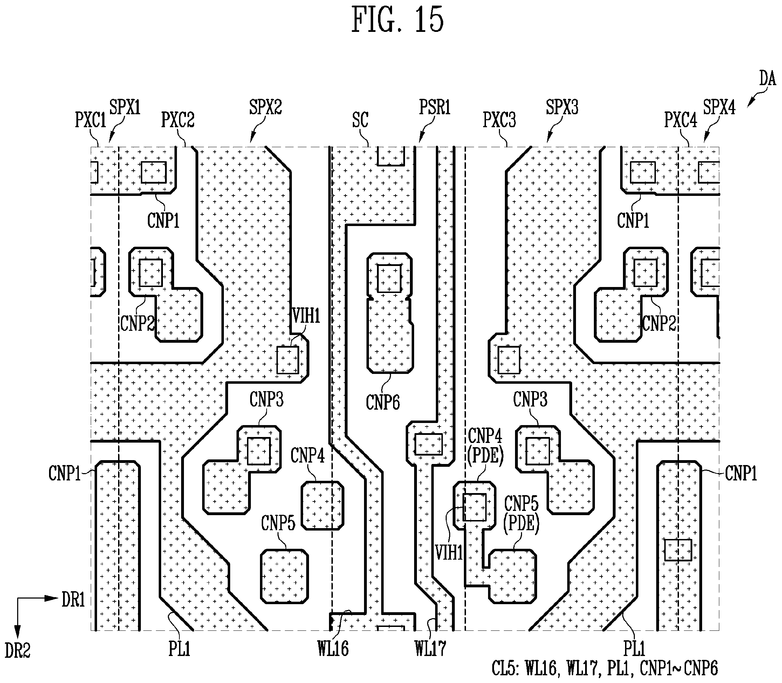

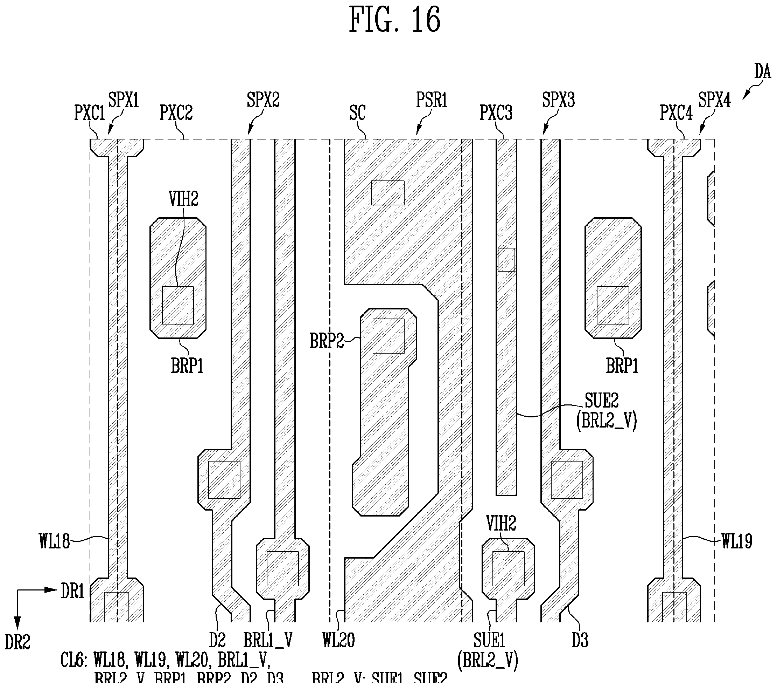

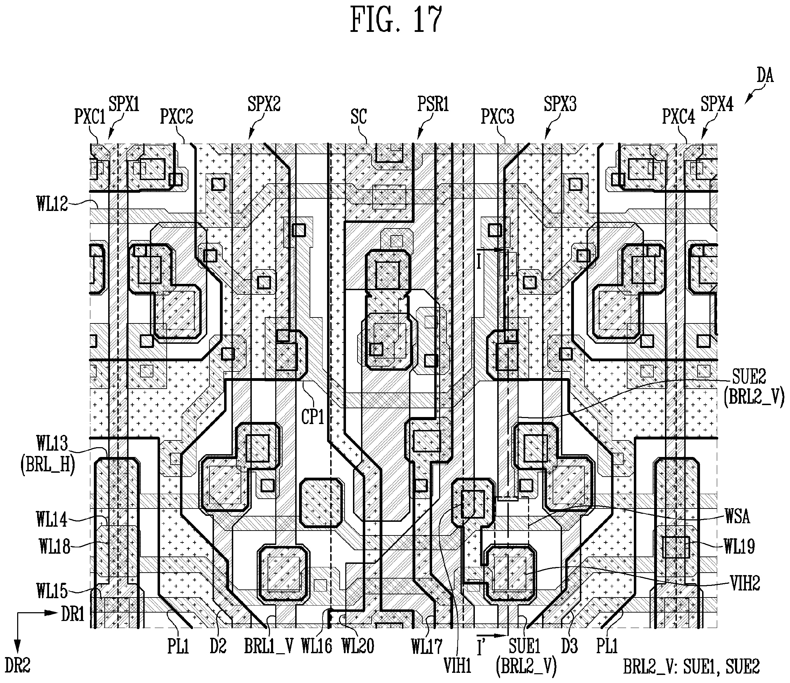

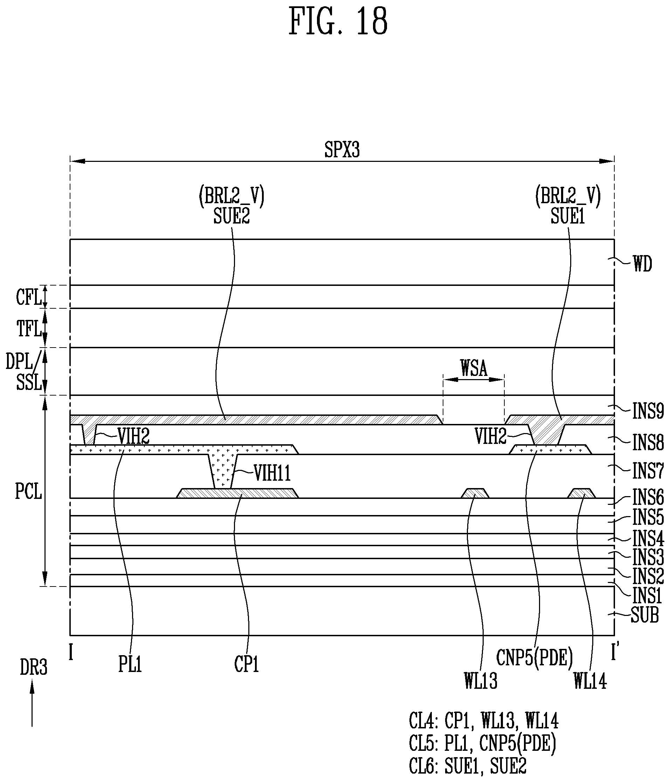

FIG. 10 is a schematic plan view illustrating the sub-pixels SPX1 to SPX4 and the light-sensing pixel PSR1 according to one or more embodiments, FIG. 11 is a schematic plan view illustrating only the first, second, fifth, sixth, seventh, eighth, ninth, and eleventh transistors T1, T2, T5, T6, T7, T8, T9, T11 and the components included in the first conductive layer CL1 in FIG. 10, FIG. 12 is a schematic plan view illustrating only the components included in the second conductive layer CL2 in FIG. 10, FIG. 13 is a schematic plan view illustrating only the third, fourth, and tenth transistors T3, T4, T10 and the components included in the third conductive layer CL3 in FIG. 10, FIG. 14 is a schematic plan view illustrating only the components included in the fourth conductive layer CL4 in FIG. 10, FIG. 15 is a schematic plan view illustrating only the components included in the fifth conductive layer CL5 in FIG. 10, FIG. 16 is a schematic plan view illustrating only the components included in the sixth conductive layer CL6 in FIG. 10, FIG. 17 is a schematic plan view illustrating only the components included in the fourth, fifth, and sixth conductive layers in FIG. 10, and FIG. 18 is a schematic cross-sectional diagram taken along the line I - I' of FIG. 17.

In FIGS. 10- 18, for the sake of simplicity of explanation, the first sub-pixel SPX1, the second sub-pixel SPX2, the third sub-pixel SPX3, the fourth sub-pixel SPX4, and the first light-sensing pixel PSR1 arranged in the same pixel row (or the same horizontal line) are shown.

Referring to FIGS. 1 - 18, the first sub-pixel SPX1, the second sub-pixel SPX2, the third sub-pixel SPX3, and the fourth sub-pixel SPX4 may be arranged in the display area DA along the first direction DR1. The first light-sensing pixel PSR1 may be disposed between the second sub-pixel SPX2 and the third sub-pixel SPX3.

Each of the first to fourth sub-pixels SPX1 to SPX4 may include a pixel circuit PXC. For example, the first sub-pixel SPX1 may include a first pixel circuit PXC1, the second sub-pixel SPX2 may include a second pixel circuit PXC2, the third sub-pixel SPX3 may include a third pixel circuit PXC3, and the fourth sub-pixel SPX4 may include a fourth pixel circuit PXC4. The first light-sensing pixel PSR1 may include a sensor circuit SC. The first pixel circuit PXC1 corresponds to the eleventh pixel circuit PXC11 of FIG. 6, the second pixel circuit PXC2 corresponds to the twelfth pixel circuit PXC12 of FIG. 6, the third pixel circuit PXC3 corresponds to the thirteenth pixel circuit PXC13 of FIG. 6, the fourth pixel circuit PXC4 corresponds to the fourteenth pixel circuit PXC14 of FIG. 6, and the sensor circuit SC corresponds to the eleventh sensor circuit SC11 of FIG. 6. Based on the sensor circuit SC, the pixel circuits on the left PXC1, PXC2 and the pixel circuits on the right PXC3, PXC4 may be mutually symmetrical and may be substantially identical. For convenience, FIGS. 10 - 17 are illustrated focusing on the second pixel circuit PXC2, the sensor circuit SC, and the third pixel circuit PXC3.

The first to fourth sub-pixels SPX1 to SPX4 may include the substrate SUB, the pixel circuit layer PCL, the display element layer DPL, the thin film encapsulation layer TFE, the color filter layer CFL, and the window WD. The first light-sensing pixel PSR1 may include the substrate SUB, the pixel circuit layer PCL, the sensor layer SSL, the thin film encapsulation layer TFE, the color filter layer CFL, and the window WD.

The substrate SUB may include a transparent insulating material to enable light transmission. The substrate SUB may be a rigid substrate or a flexible substrate.

In the pixel circuit layer PCL, the first to fourth pixel circuits PXC1 to PXC4, the sensor circuit SC, and the signal wires may be arranged.

In the display element layer DPL, the light-emitting element (see "LED" in FIG. 8) which is electrically connected to each of the first to fourth pixel circuits PXC1 to PXC4 may be arranged. In the sensor layer SSL, the light-receiving element (see "LRD" in FIG. 8) electrically connected to the sensor circuit SC may be located.

The pixel circuit layer PCL may include the first insulating layer INS1, the second insulating layer INS2, the third insulating layer INS3, the fourth insulating layer INS4, the fifth insulating layer INS5, the sixth insulating layer INS6, the seventh insulating layer INS7, the eighth insulating layer INS8, and the ninth insulating layer INS9 sequentially stacked along the third direction DR3 from one side of the substrate SUB.

In the pixel circuit layer PCL, at least one conductive layer and at least one semiconductor layer may be located. For example, the pixel circuit layer PCL may include the first semiconductor layer, the first conductive layer CL1, the second conductive layer CL2, the second semiconductor layer, the third conductive layer CL3, the fourth conductive layer CL4, the fifth conductive layer CL5, and the sixth conductive layer CL6 sequentially stacked along the third direction DR3 from one side of the substrate SUB.

The signal wires may be arranged in the display area DA where the first to fourth sub-pixels SPX1 to SPX4 and the first light-sensing pixel PSR1 are located. For example, in the display area DA, first to twentieth wires WL1 to WL20, the second and third data lines D2, D3, the first power wire PL1, and first and second vertical bridge lines BRL1_V, BRL2_V may be arranged.

The first wire WL1 extends in the first direction DR1 and may be formed of the first conductive layer CL1. The first wire WL1 may be the 3i scan line S3i described with reference to FIG. 7. One area of the first wire WL1 may be the gate electrode (hereinafter referred to as a "seventh gate electrode") of the seventh transistor T7 of each of the second and third pixel circuits PXC2, PXC3. Another area of the first wire WL1 may be the gate electrode (hereinafter referred to as an "eighth gate electrode") of the eighth transistor T8 of each of the second and third pixel circuits PXC2, PXC3.

The second wire WL2 extends in the first direction DR1 and may be spaced (e.g., spaced apart) from the first wire WL1. The second wire WL2 may be formed of the first conductive layer CL1. The second wire WL2 may be the 1i scan line S1i described with reference to FIG. 7. One area of the second wire WL2 may be the gate electrode (hereinafter referred to as a "second gate electrode") of the second transistor T2 of each of the second and third pixel circuits PXC2, PXC3.

The third wire WL3 extends in the first direction DR1 and may be spaced (e.g., spaced apart) from the first and second wires WL1, WL2. The third wire WL3 may be formed of the first conductive layer CL1. In one or more embodiments, the third wire WL3 may be the i-th light-emitting control line Ei described with reference to FIG. 7. One area of the third wire WL3 may be the gate electrode (hereinafter referred to as a "fifth gate electrode") of the fifth transistor T5 of each of the second and third pixel circuits PXC2, PXC3. Another area of the third wire WL3 may be the gate electrode (hereinafter, a "sixth gate electrode") of the sixth transistor T6 of each of the second and third pixel circuits PXC2, PXC3.

The fourth wire WL4 extends in the first direction DR1 and may be formed of the second conductive layer CL2. The fourth wire WL4 may be, but is not limited to, a dummy line that overlaps with the eighth wire WL8 formed of the third conductive layer CL3.

The fifth wire WL5 extends in the first direction DR1 and may be formed of the second conductive layer CL2. The fifth wire WL5 may be spaced (e.g., spaced apart) from the fourth wire WL4. The fifth wire WL5 may be, but is not limited to, a dummy line that overlaps with the ninth wire WL9) formed of the third conductive layer CL3.

The sixth wire WL6 extends in the first direction DR1 and may be formed of the second conductive layer CL2. The sixth wire WL6 may be spaced (e.g., spaced apart) from the fourth and fifth wires WL4, WL5. The sixth wire WL6 may be, but is not limited to, a dummy line that overlaps with the tenth wire WL10 formed of the third conductive layer CL3.

The seventh wire WL7 extends in the first direction DR1 and may be formed of the third conductive layer CL3. In one or more embodiments, the seventh wire WL7 may be the sixth power wire PL6 described with reference to FIG. 7. The seventh wire WL7 may be supplied with a common voltage (see "VCOM" in FIG. 7) (or the second initialization power supply voltage Vint2).

The eighth wire WL8 extends in the first direction DR1 and may be spaced (e.g., spaced apart) from the seventh wire WL7. The eighth wire WL8 may be formed of the third conductive layer CL3. The eighth wire WL8 may be the 4i scan line S4i described with reference to FIG. 7. One area of the eighth wire WL8 may be the gate electrode (hereinafter referred to as a "third gate electrode") of the third transistor T3 of each of the second and third pixel circuits PXC2, PXC3.

The ninth wire WL9 extends in the first direction DR1 and may be spaced (e.g., spaced apart) from the seventh and eighth wires WL7, WL8. The ninth wire WL9 may be formed of the third conductive layer CL3. The ninth wire WL9 may be the 2i scan line S2i described with reference to FIG. 7. One area of the ninth wire WL9 may be the gate electrode (hereinafter referred to as a "fourth gate electrode") of the fourth transistor T4 of each of the second and third pixel circuits PXC2, PXC3.

The tenth wire WL10 extends in the first direction DR1 and may be spaced (e.g., spaced apart) from the seventh to ninth wires WL7 to WL9. The tenth wire WL10 may be formed of the third conductive layer CL3. The tenth wire WL10 may be the sixth power wire PL6 described in the first sub-pixel SPX1 with reference to FIG. 7. The tenth wire WL10 may be supplied with the common voltage VCOM (or the second initialization power supply voltage Vint2). In one or more embodiments, the seventh wire WL7 and the tenth wire WL10 may be supplied with the same voltage, e.g., the common voltage VCOM.

The eleventh wire WL11 extends in the first direction DR1 and may be spaced (e.g., spaced apart) from the seventh to tenth wires WL7 to WL10. The eleventh wire WL11 may be formed of the third conductive layer CL3. The eleventh wire WL11 may be the reset line RSTL described with reference to FIG. 7. One area of the eleventh wire WL11 may be the gate electrode (hereinafter referred to as a "tenth gate electrode") of the tenth transistor T10 of the sensor circuit SC. The tenth gate electrode may be the tenth gate electrode GE10 described with reference to FIG. 8.

The twelfth wire WL12 extends in the first direction DR1 and may be formed of the fourth conductive layer CL4. The twelfth wire WL12 may be the 4th power wire PL4 described with reference to FIG. 7. The twelfth wire WL12 may be supplied with a bias voltage (see "VOBS" in FIG. 7). The twelfth wire WL12 may be electrically connected to the first semiconductor pattern SCP1 of the eighth transistor T8 of each of the second and third pixel circuits PXC2, PXC3.

The thirteenth wire WL13 extends in the first direction DR1 and may be spaced (e.g., spaced apart) from the twelfth wire WL12. The thirteenth wire WL13 may be formed of the fourth conductive layer CL4. The thirteenth wire WL13 may be a horizontal bridge line BRL_H. The thirteenth wire WL13 may be electrically connected to the corresponding data line from among the data lines located in the first area of the display area DA (see "DA1" in FIG. 3). The thirteenth wire WL13 may overlap with a fourth connection pattern CNP4 of each of the second and third sub-pixels SPX2, SPX3. In one or more embodiments, the thirteenth wire WL13 may be electrically connected to the fourth connection pattern CNP4 of the third sub-pixel SPX3.

The fourth connection pattern CNP4 may be formed of the fifth conductive layer CL5. The fourth connection pattern CNP4 of the second sub-pixel SPX2 may overlap with the thirteenth wire WL13, but may be physically and/or electrically disconnected to the thirteenth wire WL13. The fourth connection pattern CNP4 of the third sub-pixel SPX3 may overlap with the thirteenth wire WL13 and may be electrically connected to the thirteenth wire WL13 through the corresponding 1st via hole VIH1. In the second sub-pixel SPX2, the fourth connection pattern CNP4 may be spaced (e.g., spaced apart) from a fifth connection pattern CNP5. The fourth connection pattern CNP4 in the third sub-pixel SPX3 may be formed integrally with the fifth connection pattern CNP5 of the third sub-pixel SPX3 to form a pad electrode PDE.

The fourteenth wire WL14 extends in the first direction DR1 and may be spaced (e.g., spaced apart) from the twelfth and thirteenth wires WL12, WL13. The fourteenth wire WL14 may be formed of the fourth conductive layer CL4. The fourteenth wire WL14 may be the second power wire PL2 described with reference to FIG. 7. The fourteenth wire WL14 may be supplied with the first initialization power supply voltage (see "Vint1" in FIG. 7). The fourteenth wire WL14 may be electrically connected to the third semiconductor pattern SCP3 of the fourth transistor T4 of each of the second and third pixel circuits PXC2, PXC3.

The fifteenth wire WL15 extends in the first direction DR1 and may be spaced (e.g., spaced apart) from the twelfth to fourteenth wires WL12 to WL14. The fifteenth wire WL15 may be formed of the fourth conductive layer CL4. The fifteenth wire WL15 may be the fifth power wire PL5 described with reference to FIG. 7. The fifteenth wire WL15 may be supplied with a reset voltage (see "VRST" in FIG. 7). The fifteenth wire WL15 may be electrically connected to the fourth semiconductor pattern SCP4 of the tenth transistor T10 of the sensor circuit SC.

The sixteenth wire WL16 extends in the second direction DR2 and may be formed of the fifth conductive layer CL5. The sixteenth wire WL16 may be electrically connected to the fifteenth wire WL15 through the first via hole VIH1 that penetrates the seventh insulating layer INS7. The sixteenth wire WL16 may be located within the first light-sensing pixel PSR1 where the sensor circuit SC is located, but is not limited thereto.

The seventeenth wire WL17 extends in the second direction DR2 and may be spaced (e.g., spaced apart) from the sixteenth wire WL16. The seventeenth wire WL17 may be formed of the fifth conductive layer CL5. The seventeenth wire WL17 may be the k-th readout line (RXk, hereinafter referred to as a "readout line") described with reference to FIG. 7. The seventeenth wire WL17 may be electrically connected to an eighth conductive pattern CP8 through the first via hole VIH1 that penetrates the seventh insulating layer INS7.

The eighth conductive pattern CP8 may be formed of the fourth conductive layer CL4. The eighth conductive pattern CP8 may be located in the first light-sensing pixel PSR1 and may be electrically connected to the seventeenth wire WL17 through the corresponding first via hole VIH1. The eighth conductive pattern CP8 may be electrically connected to the second semiconductor pattern SCP2 of the eleventh transistor T11 through the first contact CNT1 penetrating the sixth insulating layer INS6, the fifth insulating layer INS5, the fourth insulating layer INS4, the third insulating layer INS3, and the second insulating layer INS2.

The eighteenth wire WL18 extends in the second direction DR2 and may be formed of the sixth conductive layer CL6. The eighteenth wire WL18 may be disposed between the first sub-pixel SPX1 and the second sub-pixel SPX2. The eighteenth wire WL18 may be the third power wire PL3 described for each of the first and second sub-pixels SPX1, SPX2 with reference to FIG. 7. The eighteenth wire WL18 may be supplied with the second initialization power supply voltage Vint2. The eighteenth wire WL18 may be electrically connected to the first connection pattern CNP1 of each of the first and second sub-pixels SPX1, SPX2 through the second via hole VIH2 that penetrates the eighth insulating layer INS8.

The first connection pattern CNP1 may be formed of the fifth conductive layer CL5. The first connection pattern CNP1 may be electrically connected to the eighteenth wire WL18 through the corresponding second via hole VIH2. The first connection pattern CNP1 may be electrically connected to the seventh conductive pattern CP7 of each of the first and second sub-pixels SPX1, SPX2 through the first via hole VIH1 that penetrates the seventh insulating layer INS7.

The seventh conductive pattern CP7 may be formed of the fourth conductive layer CL4. The seventh conductive pattern CP7 may be electrically connected to the first conductive pattern CNP1 through the corresponding first via hole VIH1. The seventh conductive pattern CP7 may be electrically connected to the first semiconductor pattern SCP1 of the seventh transistor T7 through the first contact CNT1 penetrating the sixth insulating layer INS6, the fifth insulating layer INS5, the fourth insulating layer INS4, the third insulating layer INS3, and the second insulating layer INS2 in the second sub-pixel SPX2.

The nineteenth wire WL19 extends in the second direction DR2 and may be spaced (e.g., spaced apart) from the eighteenth wire WL18. The nineteenth wire WL19 may be formed of the sixth conductive layer CL6. The nineteenth wire WL19 may be disposed between the third sub-pixel SPX3 and the fourth sub-pixel SPX4. The nineteenth wire WL19 may be electrically connected to the first connection pattern CNP1 of each of the third and fourth sub-pixels SPX3, SPX4 through the second via hole VIH2 penetrating the eighth insulating layer INS8.

The first connection pattern CNP1 may be formed of the fifth conductive layer CL5. The first connection pattern CNP1 may be electrically connected to the nineteenth wire WL19 through the corresponding second via hole VIH2. The first connection pattern CNP1 may be electrically connected to the fourteenth wire WL14 through the first via hole VIH1 that penetrates the seventh insulating layer INS7. According to one or more embodiments, the first connection pattern CNP1 may be electrically connected to the seventh conductive pattern CP7 of each of the third and fourth sub-pixels SPX3, SPX4 through another first via hole VIH1 that penetrates the seventh insulating layer INS7. The nineteenth wire WL19 may electrically connected to the fourteenth wire WL14 through the first connection pattern CNP1 and may be supplied with the first initialization power supply voltage Vint1.

The twentieth wire WL20 extends in the second direction DR2 and may be spaced (e.g., spaced apart) from the eighteenth and nineteenth wire WL18, WL19. The twentieth wire WL20 may be formed of the sixth conductive layer CL6. The twentieth wire WL20 may be located within the first light-sensing pixel PSR1. The twentieth wire WL20 may be electrically connected to the sixteenth wire WL16 formed of the fifth conductive layer CL5 through the second via hole VIH2 that penetrates the eighth insulating layer INS8. The sixteenth wire WL16 may be electrically connected to the fifteenth wire WL15 formed of the fourth conductive layer CL4 through the corresponding first via hole VIH1. The electrically connected fifteenth wire WL15, sixteenth wire WL16, and twentieth wire WL20 may be supplied with the reset voltage VRST.

In one or more embodiments, the fifteenth wire WL15 may be a horizontal power wire of the fifth power wire PL5, the sixteenth wire WL16 may be a first vertical power wire of the fifth power wire PL5, and the twentieth wire WL20 may be a second vertical power wire of the fifth power wire PL5. The fifteenth wire WL15 extending in the first direction DR1 and formed of the fourth conductive layer CL4, the sixteenth wire WL16 extending in the second direction DR2 and formed of the fifth conductive layer CL5, and the twentieth wire WL20 extending in the second direction DR2 and formed of the sixth conductive layer CL6 may be electrically connected to each other to form the fifth power wire PL5 in a mesh structure. In other words, due to the electrically connected fifteenth wire WL15, sixteenth wire WL16, and twentieth wire WL20, the fifth power wire PL5 may have the mesh structure.

The second data line D2 extends in the second direction DR2 and may be formed of the sixth conductive layer CL6. The second data line D2 may be disposed on (e.g., at) the same layer as the eighteenth to twentieth wires WL18 to WL20 and spaced (e.g., spaced apart) from the eighteenth to twentieth wires WL18 to WL20. The second data line D2 may be the j-th data line Dj described with reference to FIG. 7. The second data line D2 may be electrically connected to the first semiconductor pattern SCP1 of the second transistor T2 of the second pixel circuit PXC2.

The third data line D3 extends in the second direction DR2 and may be formed of the sixth conductive layer CL6. The third data line D3 may be disposed on (e.g., at) the same layer as the second data line D2 and may be spaced (e.g., spaced apart) from the second data line D2. The third data line D3 may be the j-th data line Dj described with reference to FIG. 7. The third data line D3 may be electrically connected to the first semiconductor pattern SCP1 of the second transistor T2 of the third pixel circuit PXC3.

A first vertical bridge line BRL1_V extends in the second direction DR2 and may be formed of the sixth conductive layer CL6. The first vertical bridge line BRL1_V may be disposed on (e.g., at) the same layer as the second and third data lines D2, D3, and spaced (e.g., spaced apart) from the second and third data lines D2, D3. The first vertical bridge line BRL1_V may overlap with a part of the second pixel circuit PXC2 within the second sub-pixel SPX2. The first vertical bridge line BRL1_V may be electrically connected to the corresponding data line from among the data lines located in the first area DA1. The first vertical bridge line BRL1_V may electrically connect the data line with the fan-out line located in the fan-out area ("FTA" area of FIG. 3) of the non-display area (see "NDA" in FIG. 3). The first vertical bridge line BRL1_V may be electrically connected to the fifth connection pattern CNP5 of the second sub-pixel SPX2 through the second via hole VIH2 penetrating the eighth insulating layer INS8.

The second vertical bridge line BRL2_V extends in the second direction DR2 and may be spaced (e.g., spaced apart) from the first vertical bridge line BRL1_V. The second vertical bridge line BRL2_V may be formed of the sixth conductive layer CL6. The second vertical bridge line BRL2_V may overlap with a part of the third pixel circuit PXC3 within the third sub-pixel SPX3. The second vertical bridge line BRL2_V may be electrically connected to the corresponding data line from among the data lines located in the first area DA. The second vertical bridge line BRL2_V may electrically connect the data line with the corresponding fan-out line located in the fan-out area FTA.

In one or more embodiments, the second vertical bridge line BRL2_V may include a first sub-electrode SUE1 and a second sub-electrode SUE2. The first sub-electrode SUE1 and the second sub-electrode SUE2 may be located in the same column along the second direction DR2 and may be spaced (e.g., spaced apart) from each other. The first sub-electrode SUE1 and the second sub-electrode SUE2 may be electrically disconnected.

The first sub-electrode SUE1 may be positioned in a lower portion within the third sub-pixel SPX3 in a plan view, and the second sub-electrode SUE2 may be positioned at a central portion and an upper portion within the third sub-pixel SPX3.

The first sub-electrode SUE1 may be electrically connected to the pad electrode PDE of the third sub-pixel SPX3 through the second via hole VIH2 penetrating the eighth insulating layer INS8. The pad electrode PDE may be formed of the fifth conductive layer CL5. One end of the pad electrode PDE may be electrically connected to the first sub-electrode SUE1 through the corresponding second via hole VIH2. The other end of the pad electrode PDE may be electrically connected to the thirteenth wire WL13 (or horizontal bridge line BRL_H) through the first via hole VIH1 that penetrates the seventh insulating layer INS7. In a plan view, the first sub-electrode SUE1 may overlap the pad electrode PDE.

The second sub-electrode SUE2 may be electrically connected to the first power wire PL1 of the third sub-pixel SPX3 through the second via hole VIH2 that penetrates the eighth insulating layer INS8. The first power wire PL1 may be formed of the fifth conductive layer CL5. In a plan view, the second sub-electrode SUE2 may be positioned so as not to overlap with the pad electrode PDE and to be spaced (e.g., spaced apart) from the second via hole VIH2 located at a connection point of the pad electrode PDE and the first sub-electrode SUE1. In a plan view, the second sub-electrode SUE2 may be positioned above the second via hole VIH2 based on the second via hole VIH2. In a plan view, the second sub-electrode SUE2 may be disposed between the seventeenth wire WL17 (or the readout wiring RXk) and the third data line D3.

The first power wire PL1 extends in the second direction DR2 and may be formed of the fifth conductive layer CL5. The first power wire PL1 may be the first power wire PL1 described with reference to FIG. 7. The first power wire PL1 may be supplied with the first power supply voltage VDD. The first power supply voltage VDD may be a direct current voltage having a constant voltage level. The first sub-pixel SPX1 and the second sub-pixel SPX2 may share one first power wire PL1, and the third sub-pixel SPX3 and the fourth sub-pixel SPX4 may share one first power wire PL1. The first power wire PL1 of the third sub-pixel SPX3 may be electrically connected to the second sub-electrode SUE2 of the second vertical bridge line BRL2_V through the corresponding second via hole VIH2. In this case, the second sub-electrode SUE2 of the second vertical bridge line BRL2_V may be supplied with the first supply voltage VDD.

In each of the second and third sub-pixels SPX2, SPX3, the first power wire PL1 may be electrically connected to the first conductive pattern CP1 formed of the fourth conductive layer CL4 through the first via hole VIH1 penetrating the seventh insulating layer INS7.

The first conductive pattern CP1 may be formed of the fourth conductive layer CL4 and electrically connected to the first power wire PL1 through the corresponding first via hole VIH1. The first conductive pattern CP1 may be electrically connected to the first semiconductor pattern SCP1 of the fifth transistor T5 of each of the second and third pixel circuits PXC2, PXC3 through the corresponding first contact CNT1 that penetrates the sixth insulating layer INS6, the fifth insulating layer INS5, the fourth insulating layer INS4, the third insulating layer INS3, and the second insulating layer INS2. The first conductive pattern CP1 may be electrically connected to the upper electrode UE formed of the second conductive layer CL2 through the corresponding first contact CNT1 that penetrates the sixth insulating layer INS6, the fifth insulating layer INS5, and the fourth insulating layer INS4.

The first pixel circuit PXC1, the second pixel circuit PXC2, the third pixel circuit PXC3, and the fourth pixel circuit PXC4 may have substantially similar or identical structures to each other. For example, the first and second pixel circuits PXC1, PXC2 located on the left side of the sensor circuit SC and the third and fourth pixel circuits PXC3, PXC4 located on the right side of the sensor circuit SC may be mutually symmetrical. In other words, the first pixel circuit PXC1 and the third pixel circuit PXC3 may be mutually symmetrical, and the second pixel circuit PXC2 and the fourth pixel circuit PXC4 may be mutually symmetrical. In one or more embodiments, the first pixel circuit PXC1 and the second pixel circuit PXC2 may be mirror-symmetrical, and the third pixel circuit PXC3 and the fourth pixel circuit PXC4 may be mirror-symmetrical, but are not limited thereto.

In the following, for convenience, the explanation will focus on the second pixel circuit PXC2 and duplicate explanations will not be repeated.

The second pixel circuit PXC2 may include first, second, third, fourth, fifth, sixth, seventh, and eighth transistors T1, T2, T3, T4, T5, T6, T7, T8 and a storage capacitor Cst.

The first transistor T1 may include a first active pattern ACT1 and a first gate electrode GE1.

The first active pattern ACT1 may be an area of the first semiconductor pattern SCP1 that overlaps with the first gate electrode GE1. The first semiconductor pattern SCP1 may be the first semiconductor layer. The first active pattern ACT1 may be the channel region of the first transistor T1.

The channel region may be, for example, a semiconductor pattern that is not doped with impurities, and may be an intrinsic semiconductor. The rest of the semiconductor pattern, except for the channel region, may be an impurity-doped semiconductor pattern.

One region of the first semiconductor pattern SCP1 that does not overlap with the first gate electrode GE1 and is connected to one side of the first active pattern ACT1 (or channel region) (e.g., the right of the first active pattern ACT1 in a plan view) may be the first contact region. One region of the first semiconductor pattern SCP1 that does not overlap with the first gate electrode GE1 and is connected to the other side of the first active pattern ACT1 (e.g., the left side of the first active pattern ACT1 in a plan view) may be the second contact region. The first contact region and the second contact region may extend in opposite directions from the first active pattern ACT1.

The first contact region may be connected to one side of the first active pattern ACT1, and connected to the first semiconductor pattern SCP1 of the second transistor T2 and the first semiconductor pattern SCP1 of the fifth transistor T5. The second contact region may be connected to the other side of the first active pattern ACT1 and may be connected to the first semiconductor pattern SCP1 of the sixth transistor T6.

The first gate electrode GE1 overlaps with the first active pattern ACT1 and may be formed of the first conductive layer CL1. The first gate electrode GE1 may be an island-shaped conductive pattern. The first gate electrode GE1 may be electrically connected to the third transistor T3 and the fourth transistor T4 via the third conductive pattern CP3.

The third conductive pattern CP3 may be formed of the fourth conductive layer CL4. One end of the third conductive pattern CP3 may be electrically connected to the first gate electrode GE1 through the corresponding first contact CNT1 penetrating the sixth insulating layer INS6, the fifth insulating layer INS5, the fourth insulating layer INS4, and the third insulating layer INS3. The other end of the third conductive pattern CP3 may be electrically connected to a region of the third semiconductor pattern SCP3 shared by the third transistor T3 and the fourth transistor T4 through the second contact CNT2 that penetrates the sixth insulating layer INS6 and the fifth insulating layer INS5.

The second transistor T2 may include a second active pattern ACT2 and a second gate electrode.

The second active pattern ACT2 may be a region of the first semiconductor pattern SCP1 that overlaps with the second wire WL2. The first semiconductor pattern SCP1 may be formed of the first semiconductor layer. The second active pattern ACT2 may be the channel region of the second transistor T2.

One region of the first semiconductor pattern SCP1 that does not overlap with the second wire WL2 and is connected to one side of the second active pattern ACT2 (e.g., the lower side of the second active pattern ACT2 in a plan view) may be the first contact region, and one region of the first semiconductor pattern SCP1 that does not overlap with the second wire WL2 and is connected to the other side of the second active pattern ACT2 (e.g., the upper side of the second active pattern ACT2 in a plan view) may be the second contact region. The first contact region may be connected to one side of the second active pattern ACT2 and electrically connected to the sixth conductive pattern CP6. The second contact region may be connected to the other side of the second active pattern ACT2 and connected to the first contact region of the first transistor T1.

The sixth conductive pattern CP6 may be formed of the fourth conductive layer CL4. The sixth conductive pattern CP6 may be electrically connected to the first semiconductor pattern SCP1 corresponding to the first contact region of the second transistor T2 through the first contact CNT1 penetrating the sixth insulating layer INS6, the fifth insulating layer INS5, the fourth insulating layer INS4, the third insulating layer INS3, and the second insulating layer INS2. The sixth conductive pattern CP6 may be electrically connected to the third conductive pattern CNP3 via the first via hole VIH1.

The third conductive pattern CNP3 may be formed of the fifth conductive layer CL5 and electrically connected to the sixth conductive pattern CP6 through the first via hole VIH1 penetrating the seventh insulating layer INS7. The third connection pattern CNP3 may be electrically connected to the second data line D2 formed of the sixth conductive layer CL6 through the second via hole VIH2 penetrating the eighth insulating layer INS8.

The first contact region of the first semiconductor pattern SCP1 of the second transistor T2 may be electrically connected to the second data line D2 through the sixth conductive pattern CP6 and the third connection pattern CNP3.

The second gate electrode may be a region of the second wire WL2 that overlaps with the second active pattern ACT2.

The third transistor T3 may include a third active pattern ACT3 and a third gate electrode.

The third active pattern ACT3 is a region of the third semiconductor pattern SCP3 that overlaps with the eighth wire WL8 and may form the channel region of the third transistor T3. The third semiconductor pattern SCP3 may be formed of the second semiconductor layer.

One region of the third semiconductor pattern SCP3 that does not overlap with the eighth wire WL8 and is connected to one side of the third active pattern ACT3 (e.g., the upper side of the third active pattern ACT3 in a plan view) may be the first contact region, and one region of the third semiconductor pattern SCP3 that does not overlap with the eighth wire WL8 and is connected to the other side of the third active pattern ACT3 (e.g., the lower side of the third active pattern ACT3 in a plan view) may be the second contact region. The first contact region may be connected to one side of the third active pattern ACT3 and may be electrically connected to the first transistor T1 and the sixth transistor T6 through the fifth conductive pattern CP5. The second contact region may be connected to the other side of the third active pattern ACT3 and may be connected to the third semiconductor pattern SCP3 of the fourth transistor T4.

The fifth conductive pattern CP5 may be formed of the fourth conductive layer CL4. One end of the fifth conductive pattern CP5 may be electrically connected to the first contact region of the third transistor T3 through the second contact CNT2 penetrating the sixth insulating layer INS6 and the fifth insulating layer INS5. The other end of the fifth conductive pattern CP5 may be electrically connected to a region of the first semiconductor pattern SCP1 shared by the first transistor T1 and the sixth transistor T6 through the first contact CNT1 that penetrates the sixth insulating layer INS6, the fifth insulating layer INS5, the fourth insulating layer INS4, the third insulating layer INS3, and the second insulating layer INS2.

The third gate electrode may be one region of the eighth wire WL8 that overlaps with the third active pattern ACT3.

The fourth transistor T4 may include a fourth active pattern ACT4 and a fourth gate electrode.

The fourth active pattern ACT4 is a region of the third semiconductor pattern SCP3 that overlaps with the ninth wire WL9 and may form the channel region of the fourth transistor T4. The third semiconductor pattern SCP3 may be formed of the second semiconductor layer.

A region of the third semiconductor pattern SCP3 that does not overlap with the ninth wire WL9 and is connected to one side of the fourth active pattern ACT4 (e.g., the upper side of the fourth active pattern ACT4 in a plan view) may be the first contact region, and one region of the third semiconductor pattern SCP3 that does not overlap with the ninth wire WL9 and is connected to the other side of the fourth active pattern ACT4 (e.g., the lower side of the fourth active pattern ACT4 in a plan view) may be the second contact region. The first contact region may be connected to one side of the fourth active pattern ACT4 and may be connected to the third semiconductor pattern SCP3 of the third transistor T3. The second contact region may be connected to the other side of the fourth active pattern ACT4 and may be electrically connected to the fourteenth wire WL14 formed of the fourth conductive layer CL4 through the corresponding second contact CNT2 penetrating the sixth insulating layer INS6 and the fifth insulating layer INS5.

The fourth gate electrode may be one region of the ninth wire WL9 that overlaps with the fourth active pattern ACT4.

The fifth transistor T5 may include a fifth active pattern ACT5 and a fifth gate electrode.

The fifth active pattern ACT5 is a region of the first semiconductor pattern SCP1 that overlaps with the third wire WL3 and may form the channel region of the fifth transistor T5. The first semiconductor pattern SCP1 may be formed of the first semiconductor layer.

One region of the first semiconductor pattern SCP1 that does not overlap with the third wire WL3 and is connected to one side of the fifth active pattern ACT5 (e.g., the upper side of the fifth active pattern ACT5 in a plan view) may be the first contact region, and one region of the first semiconductor pattern SCP1 that does not overlap with the third wire WL3 and is connected to the other side of the fifth active pattern ACT5 (e.g., the lower side of the fifth active pattern ACT5 in a plan view) may be the second contact region. The first contact region may be connected to one side of the fifth active pattern ACT5 and may be electrically connected to the first conductive pattern CP1 through the corresponding first contact CNT1. The second contact region may be connected to the other side of the fifth active pattern ACT5 and may be connected to the first semiconductor pattern SCP1 of each of the first and second transistors T1 and T2.

The fifth gate electrode may be a region of the third wire WL3 that overlaps with the fifth active pattern ACT5.

The sixth transistor T6 may include a sixth active pattern ACT6 and a sixth gate electrode.

The sixth active pattern ACT6 is a region of the first semiconductor pattern SCP1 that overlaps with the third wire WL3 that may be the channel region of the sixth transistor T6. The first semiconductor pattern SCP1 may be formed of the first semiconductor layer.

One region of the first semiconductor pattern SCP1 that does not overlap with the third wire WL3 and is connected to one side of the sixth active pattern ACT6 (e.g., the upper side of the sixth active pattern ACT6 in a plan view) may be the first contact region, and one region of the first semiconductor pattern SCP1 that does not overlap with the third wire WL3 and is connected to the other side of the sixth active pattern ACT6 (e.g., the lower side of the sixth active pattern ACT6 in a plan view) may be the second contact region. The first contact region may be connected to one side of the sixth active pattern ACT6 and the first semiconductor pattern SCP1 of the seventh transistor T7, respectively. The second contact region may be connected to the other side of the sixth active pattern ACT6 and the first semiconductor pattern SCP1 of the first transistor T1, respectively. The second contact region may be electrically connected to the fifth conductive pattern CP5 through the corresponding first contact CNT1.

The sixth gate electrode may be one region of the third wire WL3 which overlaps with the sixth active pattern ACT6.

The seventh transistor T7 may include a seventh active pattern ACT7 and a seventh gate electrode.

The seventh active pattern ACT7 may be a region of the first semiconductor pattern SCP1 that overlaps with the first wire WL1. The first semiconductor pattern SCP1 may be formed of the first semiconductor layer. The seventh active pattern ACT7 may be the channel region of the seventh transistor T7.

One region of the first semiconductor pattern SCP1 that does not overlap with the first wire WL1 and is connected to one side of the seventh active pattern ACT7 (e.g., the lower side of the seventh active pattern ACT7 in a plan view) may be the first contact region, and one region of the first semiconductor pattern SCP1 that does not overlap with the first wire WL1 and is connected to the other side of the seventh active pattern ACT7 (e.g., the upper side of the seventh active pattern ACT7 in a plan view) may be the second contact region. The first contact region may be connected to one side of the seventh active pattern ACT7, connected to the first semiconductor pattern SCP1 of the sixth transistor T6, and electrically connected to the fourth conductive pattern CP4. The second contact region may be connected to the other side of the seventh active pattern ACT7 and may be electrically connected to the first conductive pattern CP1.

The fourth conductive pattern CP4 may be formed of the fourth conductive layer CL4. The fourth conductive pattern CP4 may be electrically connected to the first semiconductor pattern SCP1 of the seventh transistor T7 through the corresponding first contact CNT1 penetrating the sixth insulating layer INS6, the fifth insulating layer INS5, the fourth insulating layer INS4, the third insulating layer INS3, and the second insulating layer INS2. The fourth conductive pattern CP4 may be electrically connected to the second connection pattern CNP2.

The second connection pattern CNP2 may be formed of the fifth conductive layer CL5. One end of the second conductive pattern CNP2 may be electrically connected to the fourth conductive pattern CP4 through the corresponding first via hole VIH1 that penetrates the seventh insulating layer INS7. The other end of the second connecting pattern CNP2 may be electrically connected to the first bridge pattern BRP1 formed of the sixth conductive layer CL6 through the corresponding second via hole VIH2.

The first bridge pattern BRP1 may be formed of the sixth conductive layer CL6. The first bridge pattern BRP1 may be electrically connected to the second connecting pattern CNP2 through the corresponding second via hole VIH2 that penetrates the eighth insulating layer INS8. The first bridge pattern BRP1 may be electrically connected to the first semiconductor pattern SCP1 of the seventh transistor T7 and the first semiconductor pattern SCP1 of the sixth transistor T6 through the second connection pattern CNP2 and the fourth conductive pattern CP4. In one or more embodiments, the first bridge pattern BRP1 may be electrically connected to the anode electrode (see "AE" in FIG. 8) of the light-emitting element (see "LED" in FIG. 8) through the third via hole (see "VIH3" in FIG. 8) penetrating the ninth insulating layer INS9.

The seventh gate electrode may be a region of the first wire WL1 that overlaps with the seventh active pattern ACT7.

The eighth transistor T8 may include the eighth active pattern ACT8 and the eighth gate electrode.

The eighth active pattern ACT8 may be a region of the first semiconductor pattern SCP1 that overlaps with the first wire WL1. The first semiconductor pattern SCP1 may be formed of the first semiconductor layer. The eighth active pattern ACT8 may be the channel region of the eighth transistor T8.

One region of the first semiconductor pattern SCP1 that does not overlap with the first wire WL1 and is connected to one side of the eighth active pattern ACT8 (e.g., the upper side of the eighth active pattern ACT8 in a plan view) may be the first contact region, and one region of the first semiconductor pattern SCP1 that does not overlap with the first wire WL1 and is connected to the other side of the eighth active pattern ACT8 (e.g., the lower side of the eighth active pattern ACT8 in a plan view) may be the second contact region. The first contact region may be connected to one side of the eighth active pattern ACT8 and may be electrically connected to the twelfth wire WL12. The second contact region may be connected to the other side of the eighth active pattern ACT8 and may be electrically connected to the second conductive pattern CP2.

The twelfth wire WL12 formed of the fourth conductive layer CL4, may be electrically connected to the first contact region of the first semiconductor pattern SCP1 of the eighth transistor T8 through the first contact CNT1 penetrating the sixth insulating layer INS6, the fifth insulating layer INS5, the fourth insulating layer INS4, the third insulating layer INS3, and the second insulating layer INS2.

The second conductive pattern CP2 may be formed of the fourth conductive layer CL4 and may be electrically connected to the second contact region of the first semiconductor pattern SCP1 of the eighth transistor T8 through the first contact CNT1 penetrating the sixth insulating layer INS6, the fifth insulating layer INS5, the fourth insulating layer INS4, the third insulating layer INS3, and the second insulating layer INS2. The second conductive pattern CP2 may be electrically connected to the first semiconductor pattern SCP1 of the fifth transistor T5 through the first contact CNT1 penetrating the sixth insulating layer INS6, the fifth insulating layer INS5, the fourth insulating layer INS4, the third insulating layer INS3, and the second insulating layer INS2.

The eighth gate electrode may be a region of the first wire WL1 that overlaps with the eighth active pattern ACT8.

The storage capacitors Cst may include a lower electrode LE and an upper electrode UE.

The lower electrode LE may be formed integrally with the first gate electrode GE1. The lower electrode LE may be formed of the first conductive layer CL1.

The upper electrode UE may overlap with the lower electrode LE and may be formed of the second conductive layer CL2. The upper electrode UE may include an opening OPN with a portion thereof removed. A region of the lower electrode LE that overlaps with the upper electrode UE may be exposed by the opening OPN. The upper electrode UE may be electrically connected to the first conductive pattern CP1.

The sensor circuit SC may be located between the second pixel circuit PXC2 and the third pixel circuit PXC3. However, the present disclosure is not limited thereto, and the location of the sensor circuit SC may be variously changed.

The sensor circuit SC may include a ninth transistor T9, a tenth transistor T10, and an eleventh transistor T11.

The ninth transistor T9 may include a ninth active pattern ACT9 and a ninth gate electrode GE9.

The ninth active pattern ACT9 may be a region of the second semiconductor pattern SCP2 that overlaps with the ninth gate electrode GE9. The second semiconductor pattern SCP2 may be formed of the first semiconductor layer. The second semiconductor pattern SCP2 may be spaced (e.g., spaced apart) from the first semiconductor pattern SCP1. The ninth active pattern ACT9 may be the channel region of the ninth transistor T9.

One region of the second semiconductor pattern SCP2 that does not overlap with the ninth gate electrode GE9 and is connected to one side of the ninth active pattern ACT9 (e.g., the left side of the ninth active pattern ACT9 in a plan view) may be the first contact region. One region of the second semiconductor pattern SCP2 that does not overlap with the ninth gate electrode GE9 and is connected to the other side of the ninth active pattern ACT9 (e.g., the right side of the ninth active pattern ACT9 in a plan view) may be the second contact region.

The first contact region may be connected to one side of the ninth active pattern ACT9 and the second semiconductor pattern SCP2 of the eleventh transistor T11, respectively. The second contact region is connected to the other side of the ninth active pattern ACT9 and may be electrically connected to the ninth conductive pattern CP9.

The ninth conductive pattern CP9 may be located within the first light-sensing pixel PSR1 and formed of the fourth conductive layer CL4. The ninth conductive pattern CP9 may be electrically connected to the first contact region of the ninth transistor T9 via the first contact CNT1 penetrating the sixth insulating layer INS6, the fifth insulating layer INS5, the fourth insulating layer INS4, the third insulating layer INS3, and the second insulating layer INS2. The ninth conductive pattern CP9 may be electrically connected to the seventh wire WL7 through the second contact CNT2 penetrating the sixth insulating layer INS6.

The ninth gate electrode GE9 may overlap with the ninth active pattern ACT9 and may be formed of the first conductive layer CL1. The ninth gate electrode GE9 may be an island-shaped conductive pattern. The ninth gate electrode GE9 may be electrically connected to the tenth transistor T10 through the tenth conductive pattern CP10.

The tenth conductive pattern CP10 may be formed of the fourth conductive layer CL4. One end of the tenth conductive pattern CP10 may be electrically connected to the ninth gate electrode GE9 through the first contact CNT1 penetrating the sixth insulating layer INS6, the fifth insulating layer INS5, the fourth insulating layer INS4, the third insulating layer INS3, and the second insulating layer INS2. The other end of the tenth conductive pattern CP1 may be electrically connected to the fourth semiconductor pattern SCP4 of the tenth transistor T10 through the second contact CNT2 that penetrates the sixth insulating layer INS6 and the fifth insulating layer INS5. The tenth conductive pattern CP10 may be electrically connected to the sixth connection pattern CNP6 through the first via hole VIH1.

The sixth connection pattern CNP6 may be formed of the fifth conductive layer CL5. The sixth connection pattern CNP6 may be electrically connected to the tenth conductive pattern CP10 through the corresponding first via hole VIH1 penetrating the seventh insulating layer INS7. The sixth connection pattern CNP6 may be electrically connected to the second bridge pattern BRP2 through the second via hole VIH2.

The second bridge pattern BRP2 may be formed of the sixth conductive layer CL6. The second bridge pattern BRP2 may be electrically connected to the sixth connection pattern CNP6) through the corresponding second via hole VIH2 penetrating the eighth insulating layer INS8. The second bridge pattern BRP2 may be electrically connected to the ninth gate electrode GE9 of the ninth transistor T9 and the fourth semiconductor pattern SCP4 of the tenth transistor T10 through the sixth connection pattern CNP6 and the tenth conductive pattern CP10.

The second bridge pattern BRP2 may be electrically connected to the first electrode (see "EL1" in FIG. 8) of the light-receiving element (see "LRD" in FIG. 8) of the sensor circuit SC. The second bridge pattern BRP2 may be formed by the same process, may include the same material, and may be provided in the same layer as the first bridge pattern BRP1.

The tenth transistor T10 may include a tenth active pattern ACT10 and a tenth gate electrode.

The tenth active pattern ACT10 may be a region of the fourth semiconductor pattern SCP4 that overlaps with the eleventh wire WL11. The fourth semiconductor pattern SCP4 may be formed of the second semiconductor layer. The fourth semiconductor pattern SCP4 may be spaced (e.g., spaced apart) from the third semiconductor pattern SCP3. The tenth active pattern ACT10 may be the channel region of the tenth transistor T10.

One area of the fourth semiconductor pattern SCP4 that does not overlap with the eleventh wire WL11 and is connected to one side of the tenth active pattern ACT10 (e.g., the upper side of the tenth active pattern ACT10 in a plan view) may be the first contact region. One region of the fourth semiconductor pattern SCP4 that does not overlap with the eleventh wire WL11 and is connected to the other side of the tenth active pattern ACT10 (e.g., the lower side of the tenth active pattern ACT10 in a plan view) may be the second contact region.

The first contact region may be connected to one side of the tenth active pattern ACT10 and may be electrically connected to the fifteenth wire WL15 through the second contact CNT2 penetrating the sixth insulating layer INS6 and the fifth insulating layer INS5. The second contact region may be connected to the other side of the tenth active pattern ACT10 and may be electrically connected to the ninth gate electrode GE9 of the ninth transistor T9 through the tenth conductive pattern CP10.

The tenth gate electrode may be a region of the eleventh wire WL11 that overlaps with the tenth active pattern ACT10.

The eleventh transistor T11 may have a dual-gate structure in which sub-transistors are connected in series to prevent leakage current. For example, the eleventh transistor T11 may include an 11a transistor T11a and an 11b transistor T11b.

The 11a transistor T11a may include an 11a active pattern ACT11a and an 11a gate electrode.

The 11a active pattern ACT11a may be a region of the second semiconductor pattern SCP2 that overlaps with the second wire WL2. The second semiconductor pattern SCP2 may be formed of the first semiconductor layer. The 11a active pattern ACT11a may be the channel region of the 11a transistor T11a.

One region of the second semiconductor pattern SCP2 that does not overlap with the second wire WL2 and is connected to one side of the 11a active pattern ACT11a (e.g., the upper side of the 11a active pattern ACT11a in a plan view) may be the first contact region. One region of the second semiconductor pattern SCP2 that does not overlap with the second wire WL2 and is connected to the other side of the 11a active pattern ACT11a (e.g., the lower side of the 11a active pattern ACT11a in a plan view) may be the second contact region.

The first contact region may be connected to one side of the 11a active pattern ACT11a and the second semiconductor pattern SCP2 of the ninth transistor T9, respectively. The second contact region may be connected to the other sides of the 11a active pattern ACT11a and the second semiconductor pattern SCP2 of the 11b transistor T11b, respectively.

The 11a gate electrode may be a region of the second wire WL2 that overlaps with the 11a active pattern ACT11a.

The 11b transistor T11b may include the 11b active pattern ACT11b and the 11b gate electrode.

The 11b active pattern ACT11b may be a region of the second semiconductor pattern SCP2 that overlaps with a protrusion protruding in the second direction DR2 from the second wire WL2 extending along the first direction DR1. The second semiconductor pattern SCP2 may be formed of the first semiconductor layer. The 11b active pattern ACT11b may be the channel region of the 11b transistor T11b.

One region of the second semiconductor pattern SCP2 that does not overlap with the protrusion of the second wire WL2 and is connected to one side of the 11b active pattern ACT11b (e.g., the left side of the 11b active pattern ACT11b in a plan view) may be the first contact region. One region of the second semiconductor pattern SCP2 that does not overlap with the protrusion of the second wire WL2 and is connected to the other side of the 11b active pattern ACT11b (e.g., the right side of the 11b active pattern ACT11b in a plan view) may be the second contact region.

The first contact region may be connected to the second semiconductor pattern SCP2 of the 11b active pattern ACT11b and the 11a transistor T11a, respectively. The second contact region may be connected to the 11b active pattern ACT11b and may be electrically connected to the seventeenth wire WL17 through the eighth conductive pattern CP8.

In one or more embodiments, the seventeenth wire WL17 (or the readout line RXk) and the third data line D3 may be formed of different conductive layers and located in different layers. For example, the seventeenth wire WL17 may be formed of the fifth conductive layer CL5 and disposed on the seventh insulating layer INS7, and the third data line D3 may be formed of the sixth conductive layer CL6 and disposed on the eighth insulating layer INS8. In this case, a separation distance between the seventeenth wire WL17 (or the readout line RXk) and the third data line D3 may be secured. In a plan view, the second vertical bridge line BRL2_V formed by the same process as the third data line D3 may be disposed between the seventeenth wire WL17 (or the readout line RXk) and the third data line D3. The second vertical bridge line BRL2_V may include the first sub-electrode SUE1 and the second sub-electrode SUE2 that are spaced (e.g., spaced apart) from each other. The first sub-electrode SUE1 may be electrically connected to the thirteenth wire WL13 corresponding to the horizontal bridge line BRL_H through the fourth and fifth connection patterns CNP4, CNP5 forming the pad electrode PDE. The second sub-electrode SUE2 may be electrically connected to the first power wire PL1 and supplied with the same voltage as the first power wire PL1, i.e., the first power supply voltage VDD. In other words, a direct current voltage with a constant voltage level may be applied to the second sub-electrode SUE2.

The second sub-electrode SUE2 supplied with first supply voltage VDD may be disposed between the seventeenth wire WL17 (or the readout line RXk) and the third data line D3 in a plan view. The second sub-electrode SUE2 may be utilized as a shielding member to reduce or prevent a coupling cap occurring between the seventeenth wire WL17 (or the readout line RXk) and the third data line D3. In other words, in the case that the separation distance between the seventeenth wire WL17 (or the readout line RXk) and the third data line D3 is secured while the second sub-electrode SUE2 is utilized as the shielding member, it is possible to reduce or prevent the phenomenon in which a data signal transmitted to the third data line D3 (or a sensing signal transmitted to the seventeenth wire WL17) is affected by the sensing signal transmitted to the seventeenth wire WL17 (or the data signal transmitted to the third data line D3). In other words, coupling of the seventeenth wire WL17 (or the readout line RXk) with an adjacent data line, e.g., the third data line D3 may be reduced or prevented. Thus, noise generated in the sensing signal applied to the seventeenth wire WL17 (or the readout line RXk) by the data signal applied to the third data line D3 may be reduced. Accordingly, the fingerprint sensitivity and fingerprint sensing accuracy in the first light-sensing pixel PSR1 may be improved, thereby further improving the reliability of the display device (see "DD" in FIG. 1).

According to the embodiment described above, the second sub-electrode SUE2 may be electrically connected to the first power wire PL1 and utilized as a power wire by being supplied with the first power supply voltage VDD. In this case, the wiring resistance of the first power wire PL1 is reduced, so that the failure caused by the signal delay of the first power wire PL1 can be prevented.

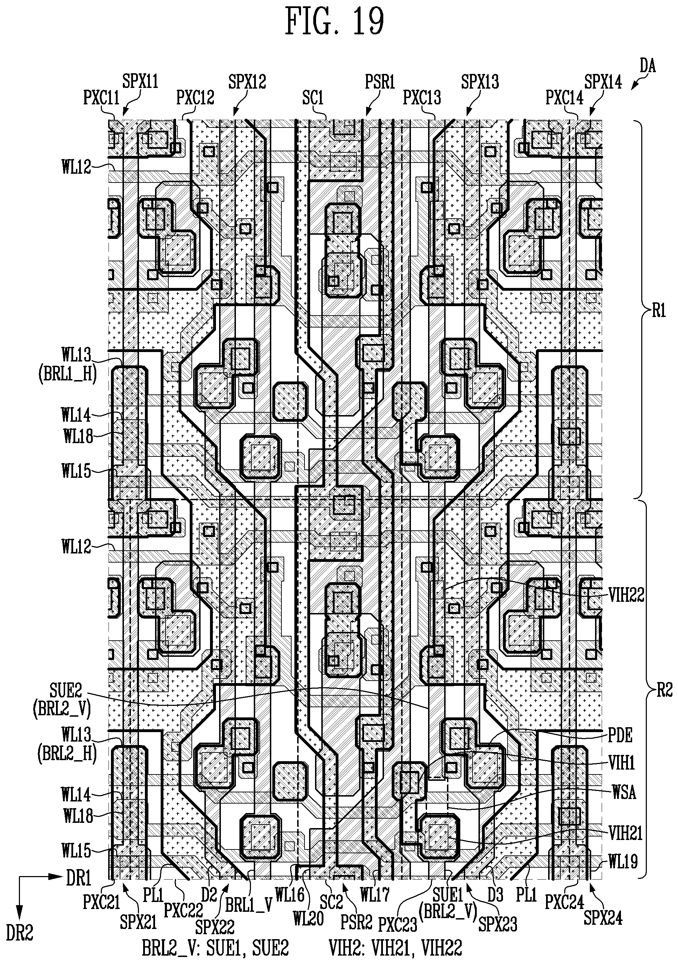

FIG. 19 is a schematic plan view illustrating sub-pixels and light-sensing pixels arranged in a first and a second pixel rows R1, R2 located in one area of a display area DD of a display device according to one or more embodiments.

For ease of explanation, in FIG. 19, only components included in the fourth conductive layer, the fifth conductive layer, and the sixth conductive layer are shown in the sub-pixels and the light-sensing pixels arranged in the first and second pixel rows R1, R2.

In FIG. 19, to avoid redundant explanation, the following description focuses on differences from the above-described embodiments.

Referring to FIG. 19, in a first pixel row R1, an eleventh sub-pixel SPX11 (or a first sub-pixel), a twelfth sub-pixel SPX12 (or a second sub-pixel), a thirteenth sub-pixel SPX13 (or a third sub-pixel), and a fourteenth sub-pixel SPX14 (or a fourth sub-pixel) may be arranged along the first direction DR1. In a second pixel row R2, a 21st sub-pixel SPX21 (or a first sub-pixel), a 22nd sub-pixel SPX22 (or a second sub-pixel), a 23rd sub-pixel SPX23 (or a third sub-pixel), and a 24th sub-pixel SPX24 (or a fourth sub-pixel) may be arranged along the first direction DR1. In the first pixel row R1, a first light-sensing pixel PSR1 may be located between the twelfth sub-pixel SPX12 and the thirteenth sub-pixel SPX13. In the second pixel row R2, a second light-sensing pixel PSR2 may be located between the 22nd sub-pixel SPX22 and the 23rd sub-pixel SPX23.

A first horizontal bridge line BRL1_H (or a thirteenth wire WL13) extending in the second direction DR2 may be provided in the first pixel row R1, and a second horizontal bridge line BRL2_H (or the thirteenth wire WL13) extending in the second direction DR2 and spaced from the first horizontal bridge line BRL1_H may be provided in the second pixel row R2. However, in one or more other embodiments, the first horizontal bridge line BRL1_H (or a thirteenth wire WL13) may extend in the first direction DR1 and the second horizontal bridge line BRL2_H may extend in the first direction DR1 and spaced from the first horizontal bridge line BRL1_H.

The eleventh sub-pixel SPX11 may include an eleventh pixel circuit PXC11, the twelfth sub-pixel SPX12 may include a twelfth pixel circuit PXC12, the thirteenth sub-pixel SPX13 may include a thirteenth pixel circuit PXC13, and the fourteenth sub-pixel SPX14 may include a fourteenth pixel circuit PXC14. A first light-sensing pixel PSR1 may include a first sensor circuit SC1.

The 21st sub-pixel SPX21 may include a 21st pixel circuit PXC21, the 22nd sub-pixel SPX22 may include a 22nd pixel circuit PXC22, the 23rd sub-pixel SPX23 may include a 23rd pixel circuit PXC23, and the 24th sub-pixel SPX24 may include a 24th pixel circuit PXC24. A second light-sensing pixel PSR2 may include a second sensor circuit SC2.

A first vertical bridge line BRL1_V may be commonly provided to the twelfth sub-pixel SPX12 and the 22nd sub-pixel SPX22 adjacent in the second direction DR2. A second vertical bridge line BRL2_V may be commonly provided to the thirteenth sub-pixel SPX13 and the 23rd sub-pixel SPX23 adjacent in the second direction DR2.

In one or more embodiments, the second vertical bridge line BRL2_V may be separated into a first sub-electrode SUE1 and a second sub-electrode SUE2 by disconnecting (or removing) one area in a wiring separation area WSA. The wiring separation area WSA may be an area where the second vertical bridge line BRL2_V is separated into the first sub-electrode SUE1 and the second sub-electrode SUE2 with respect to a 21st via hole VIH21 in the 23rd sub-pixel SPX23. The second vertical bridge line BRL2_V may include the first sub-electrode SUE1 electrically connected to a pad electrode PDE in the 23rd sub-pixel SPX23 and the second sub-electrode SUE2 electrically disconnected to the pad electrode PDE and spaced (e.g., spaced apart) from the first sub-electrode SUE1 in the second direction DR2.

The first sub-electrode SUE1 may be electrically connected to the pad electrode PDE formed of the fifth conductive layer (see "CL5" in FIG. 15) through a second via hole VIH2, for example, the 21st via hole VIH21 penetrating an eighth insulating layer (see "INS8" in FIG. 18). The pad electrode PDE may be electrically connected to the second horizontal bridge line BRL2_H through a first via hole VIH1 that penetrates the seventh insulating layer (see "INS7" in FIG. 18).

The second sub-electrode SUE2 may be electrically connected to a first power wire PL1 of the 23rd sub-pixel SPX23 through the second via hole VIH2, e.g., a 22nd via hole VIH22 that penetrates the eighth insulating layer INS8. According to one or more embodiments, the second sub-electrode SUE2 may be electrically connected to the first power wire PL1 in the thirteenth sub-pixel SPX13.

In a plan view, the second sub-electrode SUE2 may be located on the upper side of the first sub-electrode SUE1 (or the 21st via hole VIH21). The second sub-electrode SUE2 may extend from the upper side of the 21st via hole VIH21 in the 23rd sub-pixel SPX23 to the 13th sub-pixel SPX13 in the opposite direction to the second direction DR2.

In one or more embodiments, the second vertical bridge line BRL2_V may be separated into the first sub-electrode SUE1 and the second sub-electrode SUE2 at the wiring separation area WSA located above a connection point (for example, a point where the 21st via hole VIH21 is located) where it is electrically connected to the second horizontal bridge line BRL2_H. The first sub-electrode SUE1 may be electrically connected to the second horizontal bridge line BRL2_H through the pad electrode PDE and electrically connected to the corresponding data line located in the first region of the display area DA (see "A1" in FIG. 3). In other words, the first sub-electrode SUE1 may be electrically connected to the second horizontal bridge line BRL2_H and be utilized as the bridge line BRL described with reference to FIGS. 3 and 4. The second sub-electrode SUE2 may be electrically connected to the first power wire PL1 through the 22nd via hole VIH22 and utilized as the first power wire PL1. Accordingly, the second sub-electrode SUE2 may be supplied with the first power supply voltage (see "VDD" in FIG. 7) with a constant voltage level. In a plan view, the second sub-electrode SUE2 supplied with the first power supply voltage VDD may be arranged between the seventeenth wire WL17 (or the readout line) and the third data line D3 and may be utilized as a shielding member to reduce or prevent coupling caps that may occur between the seventeenth wire WL17 and the third data line D3.

In the above embodiments, the second sub-electrode SUE2 of the second vertical bridge line BRL2_V is described to be electrically connected to the first power wire PL1 and supplied with the first power supply voltage VDD, but not limited thereto. According to one or more embodiments, the second sub-electrode SUE2 of the second vertical bridge line BRL2_V may be electrically connected to another power wire supplied with a direct current voltage having a constant voltage level. For example, the second sub-electrode SUE2 of the second vertical bridge line BRL2_V may be electrically connected to the electrode (see "EP" in FIG. 7), which is supplied with a second supply voltage (see "VSS" in FIG. 7).

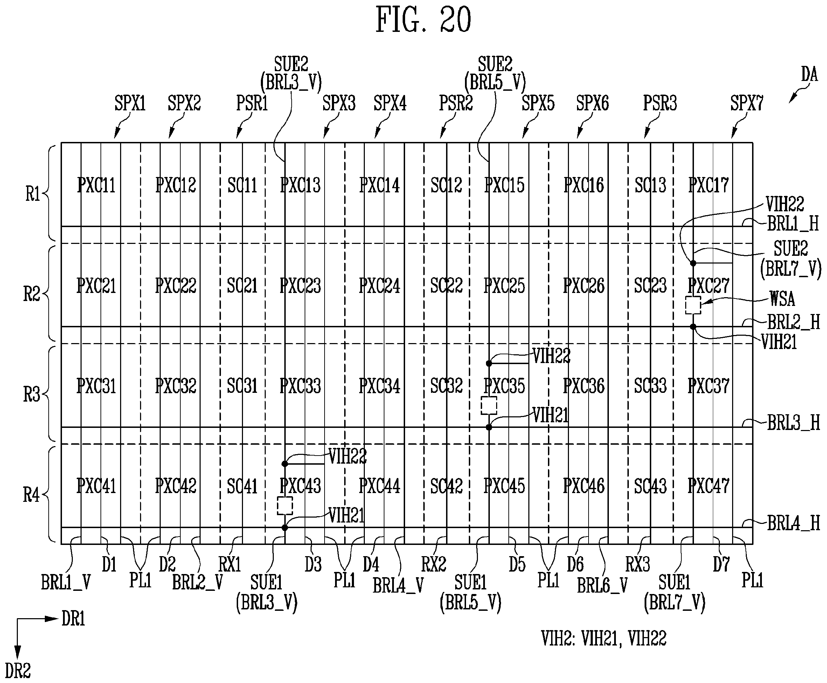

FIG. 20 is a schematic drawing illustrating a connection relationship of some wires in one area of a display area DA of a display device according to one or more embodiments.

In FIG. 20, for ease of explanation, only some of the signal wires in the sub-pixels and light-sensing pixels arranged in each of the first to fourth pixel rows R1 to R4 are illustrated.

In FIG. 20, in order to avoid redundant explanation, differences from the above-described embodiment will be mainly explained.

Referring to FIG. 20, the display area DA may be divided into pixel rows R1 to R4. The pixel rows R1 to R4 extend in the first direction DR1 and may be arranged along the second direction DR2. Each of the pixel rows R1 to R4 may include first to seventh sub-pixels SPX1 to SPX7. The first to seventh sub-pixels SPX1 to SPX7 may include pixel circuits. Each of the pixel rows R1 to R4 may include first to third light-sensing pixels PSR1 to PSR3. The first to third light-sensing pixels PSR1 to PSR3 may include sensor circuits.

In one or more embodiments, in each of the first to fourth pixel rows R1 to R4, sub-pixels SPX1 to SPX7 may be arranged in the order of the first sub-pixel SPX1, the second sub-pixel SPX2, the third sub-pixel SPX3, the fourth sub-pixel SPX4, the fifth sub-pixel SPX5, the sixth sub-pixel SPX6, and the seventh sub-pixel SPX7 with respect to the first direction DR1. In each of the first to fourth pixel rows R1 to R4, a first light-sensing pixel PSR1 may be disposed between the second sub-pixel SPX2 and the third sub-pixel SPX3, a second light-sensing pixel PSR2 may be disposed between the fourth sub-pixel SPX4 and the fifth sub-pixel SPX5, and a third light-sensing pixel PSR3 may be disposed between the sixth sub-pixel SPX6 and the seventh sub-pixel SPX7.

In the first pixel row R1, pixel circuits PXC11 to PXC17 corresponding to the sub-pixels SPX1 to SPX7 of the first pixel row R1 may be arranged along the first direction DR1. In the first pixel row R1, sensor circuits SC11 to SC13 corresponding to the light-sensing pixels PSR1 to PSR3 of the first pixel row R1 may be arranged along the first direction DR1.

In the second pixel row R2, pixel circuits PXC21 to PXC27 corresponding to the sub-pixels SPX1 to SPX7 of the second pixel row R2 may be arranged along the first direction DR1. In the second pixel row R2, sensor circuits SC21 to SC23 corresponding to the light-sensing pixels PSR1 to PSR3 of the second pixel row R2 may be arranged along the first direction DR1.

In the third pixel row R3, pixel circuits PXC31 to PXC37 corresponding to the sub-pixels SPX1 to SPX7 of the third pixel row R3 may be arranged along the first direction DR1. In the third pixel row R3, sensor circuits SC31 to SC33 corresponding to the light-sensing pixels PSR1 to PSR3 of the third pixel row R3 may be arranged along the first direction DR1.

In the fourth pixel row R4, pixel circuits PXC41 to PXC47 corresponding to the sub-pixels SPX1 to SPX7 of the fourth pixel row R4 may be arranged along the first direction DR1. In the fourth pixel row R4, sensor circuits SC41 to SC43 corresponding to the light-sensing pixels PSR1 to PSR3 of the fourth pixel row R4 may be arranged along the first direction DR1.

A first horizontal bridge line BRL1_H may be disposed in the first pixel row R1, a second horizontal bridge line BRL2_H may be disposed in the second pixel row R2, a third horizontal bridge line BRL3_H may be disposed in the third pixel row R3, and a fourth horizontal bridge line BRL4_H may be disposed in the fourth pixel row R4.

In the first sub-pixels SPX1 of the first to fourth pixel rows R1 to R4, a first vertical bridge line BRL1_V, a first data line D1, and a first power wire PL1 may be arranged. In the second sub-pixels SPX2 of the first to fourth pixel rows R1 to R4, a second vertical bridge line BRL2_V, a second data line D2, and the first power wire PL1 may be arranged. In the third sub-pixels SPX3 of the first to fourth pixel rows R1 to R4, a third vertical bridge line BRL3_V, a third data line D3, and the first power wire PL1 may be arranged. In the fourth sub-pixels SPX4 of the first to fourth pixel rows R1 to R4, a fourth vertical bridge line BRL4_V, a fourth data line D4, and the first power wire PL1 may be arranged. In the fifth sub-pixels SPX5 of the first to fourth pixel rows R1 to R4, a fifth vertical bridge line BRL5_V, a fifth data line D5, and the first power wire PL1 may be arranged. In the sixth sub-pixels SPX6 of the first to fourth pixel rows R1 to R4, a sixth vertical bridge line BRL6_V, a sixth data line D6, and the first power wire PL1 may be arranged. In the seventh sub-pixels SPX7 of the first to fourth pixel rows R1 to R4, a seventh vertical bridge line BRL7_V, a seventh data line D7, and the first power wire PL1 may be arranged.

A first readout line RX1 may be located in the first light-sensing pixel PSR1 of the first to fourth pixel rows R1 to R4. A second readout line RX2 may be located in the second light-sensing pixel PSR2 of the first to fourth pixel rows R1 to R4. A third readout line RX3 may be located in the third light-sensing pixel PSR3 of the first to fourth pixel rows R1 to R4.

In a plan view, the third vertical bridge line BRL3_V may be disposed between the first readout line RX1 and the third data line D3, the fifth vertical bridge line BRL5_V may be disposed between the second readout line RX2 and the fifth data line D5, and the seventh vertical bridge line BRL7_V may be disposed between the third readout line RX3 and the seventh data line D7.

Each of the third, fifth, and seventh vertical bridge lines BRL3_V, BRL5_V, and BRL7_V may be separated into a first sub-electrode SUE1 and a second sub-electrode SUE2 by removing one area from the wiring separation area WSA. In other words, each of the third, fifth, and seventh vertical bridge lines BRL3_V, BRL5_V, BRL7_V may include the first sub-electrode SUE1 and the second sub-electrode SUE2 spaced (e.g., spaced apart) from each other. The first sub-electrode SUE1 and the second sub-electrode SUE2 may be located in the same column in the second direction DR2.

The first sub-electrode SUE1 of each of the third, fifth, and seventh vertical bridge lines BRL3_V, BRL5_V, BRL7_V may be electrically connected to the corresponding horizontal bridge line via a second via hole VIH2. For example, the first sub-electrode SUE1 of the third vertical bridge line BRL3_V may be electrically connected to the fourth horizontal bridge line BRL4_H through the 21st vial hole VIH21. The first sub-electrode SUE1 of the fifth vertical bridge line BRL5_V may be electrically connected to the third horizontal bridge line BRL3_H through the 21st via hole VIH21. The first sub-electrode SUE1 of the seventh vertical bridge line BRL7_V may be electrically connected to the second horizontal bridge line BRL2_H through the 21st via hole VIH21.

The second sub-electrode SUE2 of each of the third, fifth, and seventh vertical bridge lines BRL3_V, BRL5_V, BRL7_V may be electrically connected to the first power wire PL1 via the second via hole VIH2. For example, the second sub-electrode SUE2 of the third vertical bridge line BRL3_V may be electrically connected to the first power wire PL1 located in the third sub-pixel SPX3 of the fourth pixel row R4 through the 22nd vial hole VIH22. The second sub-electrode SUE2 of the fifth vertical bridge line BRL5_V may be electrically connected to the first power wire PL1 of the fifth sub-pixel SPX5 of the third pixel row R3 through the 22nd via hole VIH22. The second sub-electrode SUE2 of the seventh vertical bridge line BRL7_V may be electrically connected to the first power wire PL1 of the seventh sub-pixel SPX7 of the second pixel row R2 through the 22nd via hole VIH22.

The second sub-electrode SUE2 of the third vertical bridge line BRL3_V may extend from the fourth pixel row R4 to the first pixel row R1 in a direction opposite to the second direction DR2 based on the 21st via hole VIH21 (or the wiring isolation area WSA), which is a connection point between the fourth horizontal bridge line BRL4_H and the first sub-electrode SUE1 of the third vertical bridge line BRL3_V.

The second sub-electrode SUE2 of the fifth vertical bridge line BRL5_V may extend from the third pixel row R3 to the first pixel row R1 along a direction opposite to the second direction DR2 based on the 21st via hole VIH21 (or the wiring separation area WSA), which is a connection point of the third horizontal bridge line BRL3_H and the first sub-electrode SUE1 of the fifth vertical bridge line BRL5_V.

The second sub-electrode SUE2 of the seventh vertical bridge line BRL7_V may extend from the second pixel row R2 to the first pixel row R1 along a direction opposite to the second direction DR2 based on the 21st via hole VIH21 (or the wiring separation area WSA), which is a connection point of the second horizontal bridge line BRL2_H and the first sub-electrode SUE1 of the seventh vertical bridge line BRL7_V.

The second sub-electrode SUE2 of the third vertical bridge line BRL3_V may be electrically connected to the corresponding first power wire PL1 and may be supplied with the first power supply voltage (see "VDD" in FIG. 7) from the first power wire PL1. The second sub-electrode SUE2 of the third vertical bridge line BRL3_V may be disposed between the first readout line RX1 and the third data line D3 so that the coupling cap that may occur between the first readout line RX1 and the third data line D3 may be reduced or prevented.

The second sub-electrode SUE2 of the fifth vertical bridge line BRL5_V may be electrically connected to the corresponding first power wire PL1 and may be supplied with the first power supply voltage VDD from the first power wire PL1. The second sub-electrode SUE2 of the fifth vertical bridge line BRL5_V may be disposed between the second readout line RX2 and the fifth data line D5 so that the coupling cap that may occur between the second readout line RX2 and the fifth data line D5 may be reduced or prevented.

The second sub-electrode SUE2 of the seventh vertical bridge line BRL7_V may be electrically connected to the corresponding first power wire PL1 and may be supplied with the first power supply voltage VDD from the first power wire PL1. The second sub-electrode SUE2 of the seventh vertical bridge line BRL7_V may be disposed between the third readout line RX3 and the seventh data line D7 so that the coupling cap that may occur between the third readout line RX3 and the seventh data line D7 may be reduced or prevented.

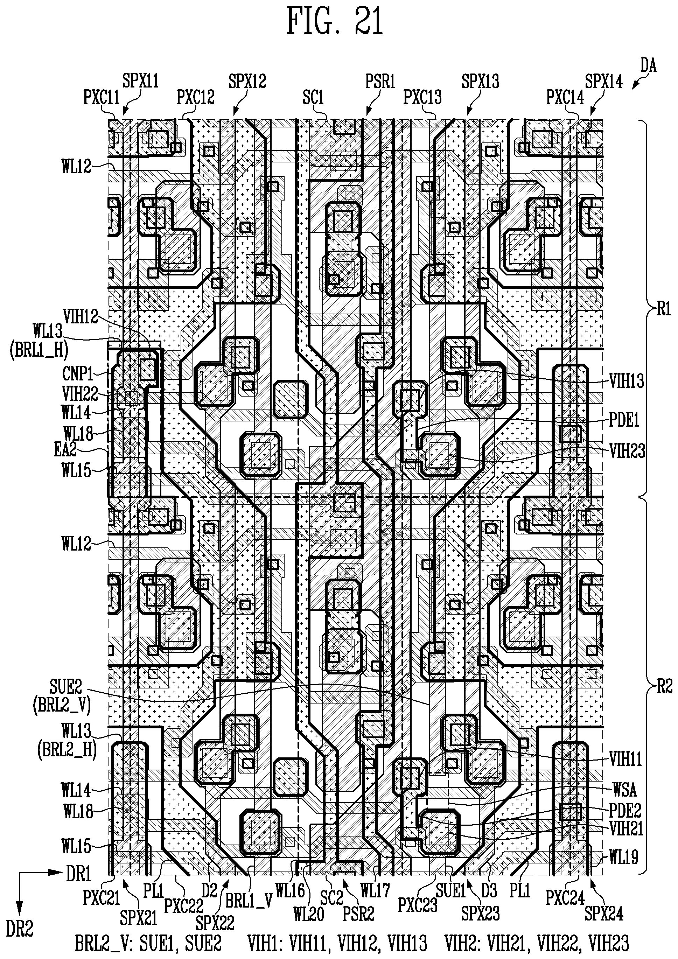

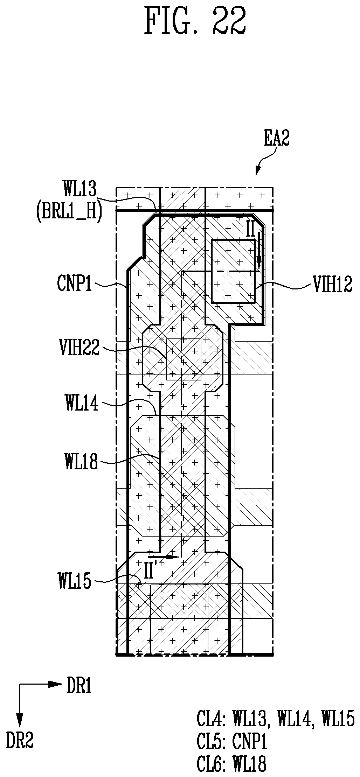

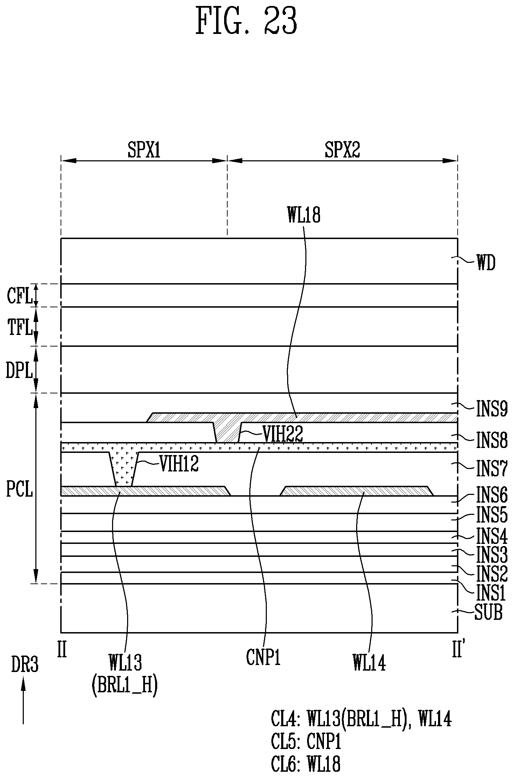

FIG. 21 is a schematic plan view illustrating sub-pixels and light-sensing pixels arranged in a first and a second pixel rows R1, R2 located in one area of a display area DD of a display device according to one or more embodiments, FIG. 22 is a schematic enlarged view illustrating a portion EA2 of FIG. 21, and FIG. 23 is a schematic cross-sectional diagram taken along the line II to II' of FIG. 22.

In FIGS. 21 - 23, for ease of explanation, only components included in a fourth conductive layer CL4, a fifth conductive layer CL5, and a sixth conductive layer CL6 are shown in the sub-pixels arranged in the first and second pixel rows R1, R2 and the light-sensing pixels.

In FIGS. 21 - 23, in order to avoid redundant explanation, differences from the above-described embodiments will be mainly explained.

Referring to FIGS. 21 - 23, a first horizontal bridge line BRL1_H (or a thirteenth wire WL13) extending in the second direction DR2 may be provided in the first pixel row R1, and a second horizontal bridge line BRL2_H (or a thirteenth wiring WL13) extending in the second direction DR2 and spaced (e.g., spaced apart) from the first horizontal bridge line BRL1_H may be provided in the second pixel row R2. However, in one or more other embodiments, the first horizontal bridge line BRL1_H may extend in the first direction DR1 and the second horizontal bridge line BRL2_H may extend in the first direction DR1 and spaced from the first horizontal bridge line BRL1_H.

A second vertical bridge line BRL2_V may be provided commonly to a thirteenth sub-pixel SPX13 and a 23rd sub-pixel SPX23 adjacent in the second direction DR2.

In one or more embodiments, the second vertical bridge line BRL2_V may be separated into a first sub-electrode SUE1 and a second sub-electrode SUE2 by disconnecting (or removing) one area in a wiring separation area WSA. The second vertical bridge line BRL2_V may include the first sub-electrode SUE1 electrically connected to a second pad electrode PDE2 in the 23rd sub-pixel SPX23 and the second sub-electrode SUE2 electrically disconnected to the second pad electrode PDE2 and spaced (e.g., spaced apart) from the first sub-electrode SUE2 in the second direction DR2.

The first sub-electrode SUE1 may be electrically connected to the second pad electrode PDE2 formed of the fifth conductive layer CL5 through a single second via hole VIH2 (e.g., a 21st via hole VIH21) penetrating an eighth insulating layer INS8. The second pad electrode PDE2 may be electrically connected to the second horizontal bridge line BRL2_H through a single first via hole VIH1 (e.g., an eleventh via hole VIH11) penetrating a seventh insulating layer INS7. The second horizontal bridge line BRL2_H may be electrically connected to the first sub-electrode SUE1 of the second vertical bridge line BRL2_V through the second pad electrode PDE2.

The second sub-electrode SUE2 may be electrically connected to a first pad electrode PDE1 formed of the fifth conductive layer CL5 and located in a thirteenth sub-pixel SPX13 through the second via hole VIH2, for example, a 23rd via hole VIH23, which penetrates the eighth insulating layer INS8. The first pad electrode PDE1 may be electrically connected to the first horizontal bridge line BRL1_H formed of the fourth conductive layer CL4 through a single first via hole VIH1, for example, a thirteenth via hole VIH13, which penetrates the seventh insulating layer INS7. In other words, the second sub-electrode SUE2 may be electrically connected to the first horizontal bridge line BRL1_H through the first pad electrode PDE1.

In one or more embodiments, the second sub-electrode SUE2 may be electrically disconnected to the second horizontal bridge line BRL2_H located in the second pixel row R2, and may be electrically connected to the first horizontal bridge line BRL1_H located in the first pixel row R1.

In one or more embodiments, the first horizontal bridge line BRL1_H may be electrically connected to a first connection pattern CNP1 formed of the fifth conductive layer CL5 in a twelfth sub-pixel SPX12. The first connection pattern CNP1 may be electrically connected to the first horizontal bridge line BRL1_H formed of the fourth conductive layer CL4 through the single first via hole VIH1, for example, a twelfth via hole VIH12, penetrating the seventh insulating layer INS7. The first connection pattern CNP1 may be electrically connected to an eighteenth wire WL18 formed of the sixth conductive layer CL6 at the boundary between an eleventh sub-pixel SPX11 and a twelfth sub-pixel SPX12. For example, the eighteenth wire WL18 may be electrically connected to the first connection pattern CNP1 through the single second via hole VIH2, for example, a 22nd via hole VIH22, penetrating the eighth insulating layer INS8.

In one or more embodiments, the second sub-electrode SUE2 electrically connected to the first horizontal bridge line BRL1_H may be electrically connected to the eighteenth wire WL18 through the first connection pattern CNP1. The eighteenth wire WL18 may be supplied with the second initialization power supply voltage Vint2 described with reference to FIG. 7. The second initialization power supply voltage Vint2 may be a direct current voltage with a constant voltage level. In a plan view, the second sub-electrode SUE2 of the second vertical bridge line BRL2_V supplied with the second initialization power supply voltage Vint2 may be disposed between a seventeenth wire WL17 (or a readout line) and a third data line D3 to reduce or prevent coupling caps that may occur between the seventeenth wire WL17 and the third data line D3.

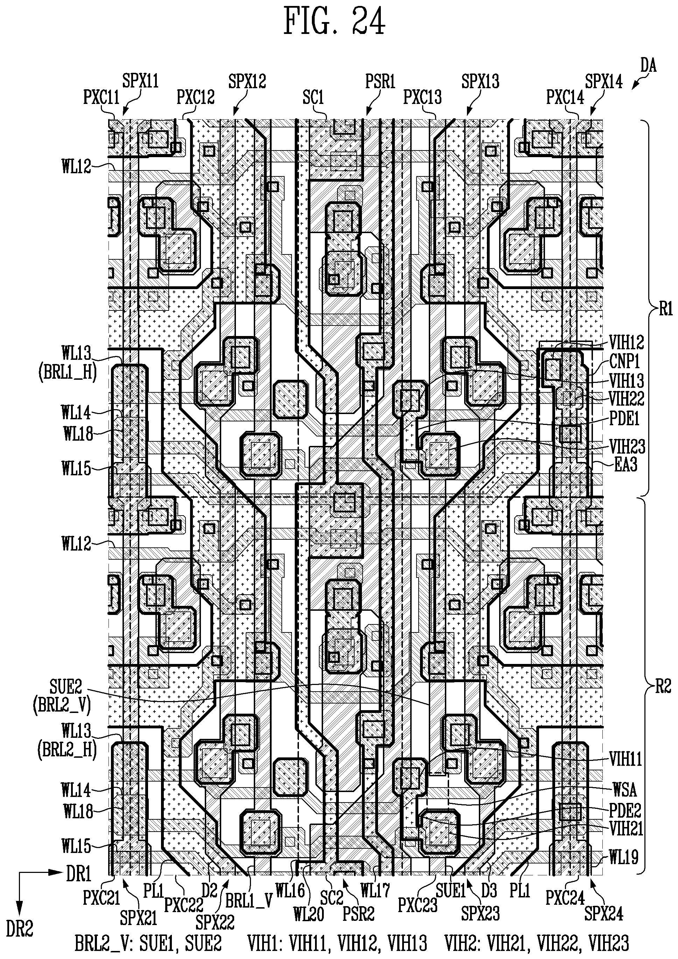

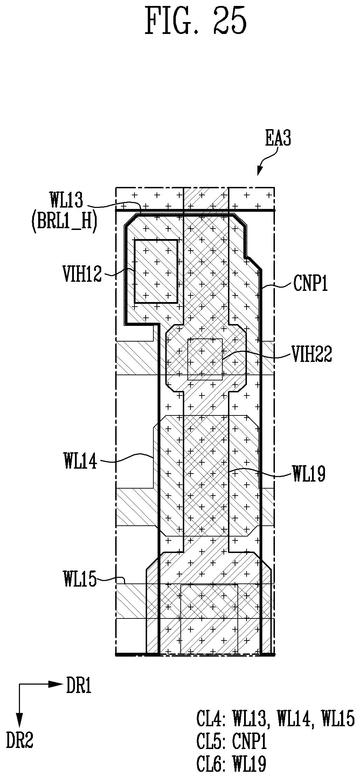

FIG. 24 is a schematic plan view illustrating sub-pixels and light-sensing pixels arranged in a first and a second pixel rows R1, R2 located in one area of a display area DA of a display device according to one or more embodiments, and FIG. 25 is a schematic enlarged view illustrating a portion EA3 of FIG. 24.

In FIGS. 24 and 25, for ease of explanation, only components included in a fourth conductive layer CL4, a fifth conductive layer CL5, and a sixth conductive layer CL6 are shown in the sub-pixels and the light-sensing pixels arranged in the first and second pixel rows R1, R2.

In FIGS. 24 and 25, in order to avoid redundant explanation, differences from the above-described embodiments will be mainly explained.

Referring to FIGS. 24 and 25, a first horizontal bridge line BRL1_H extending in the second direction DR2 (or a thirteenth wire WL13) may be provided in the first pixel row R1, and a second horizontal bridge line BRL2_H (or a thirteenth wire WL13) extending in the second direction DR1 and spaced from the first horizontal bridge line BRL1_H may be provided in the second pixel row R2. However, in one or more other embodiments, the first horizontal bridge line BRL1_H may extend in the first direction DR1 and the second horizontal bridge line BRL2_H may extend in the first direction DR1 and spaced from the first horizontal bridge line BRL1_H.

A second vertical bridge line BRL2_V may be provided commonly to a thirteenth sub-pixel SPX13 and a 23rd sub-pixel SPX23 adjacent in the second direction DR2.

In one or more embodiments, the second vertical bridge line BRL2_V may be separated into a first sub-electrode SUE1 and a second sub-electrode SUE2 by disconnecting (or removing) one area in a wiring separation area WSA. The second vertical bridge line BRL2_V may include the first sub-electrode SUE1 electrically connected to a second pad electrode PDE2 in the 23rd sub-pixel SPX23 and the second sub-electrode SUE2 electrically disconnected to the second pad electrode PDE2 and spaced (e.g., spaced apart) from the first sub-electrode SUE1 in the second direction DR2.

In one or more embodiments, the second sub-electrode SUE2 may be electrically connected to a first pad electrode PDE1 located in the thirteenth sub-pixel SPX13 and may be electrically connected to the first horizontal bridge line BRL1_H through the first pad electrode PDE1. The second sub-electrode SUE2 may be electrically disconnected to the second horizontal bridge line BRL2_H located in the second pixel row R2 and may be electrically connected to the first horizontal bridge line BRL1_H located in the first pixel row R1.

In one or more embodiments, the first horizontal bridge line BRL1_H may be electrically connected to a first connection pattern CNP1 formed of the fifth conductive layer CL5 in the thirteenth sub-pixel SPX13. The first connection pattern CNP1 may be electrically connected to the first horizontal bridge line BRL1_H formed of the fourth conductive layer CL4 through a single first via hole VIH1, for example, a twelfth via hole VIH12, penetrating the seventh insulating layer (see "INS7" in FIG. 23). The first connection pattern CNP1 may be electrically connected to a nineteenth wire WL19 formed of the sixth conductive layer CL6 at the boundary between the thirteenth sub-pixel SPX13 and a fourteenth sub-pixel SPX14. For example, the nineteenth wire WL19 may be electrically connected to the first connection pattern CNP1 through a single second via hole VIH2, for example, a 22nd via hole VIH22, penetrating the eighth insulating layer (see "INS8" in FIG. 23).

In one or more embodiments, the second sub-electrode SUE2 electrically connected to the first horizontal bridge line BRL1_H may be electrically connected to the nineteenth wire WL19 through the first connection pattern CNP1. The nineteenth wire WL19 may be supplied with the first initialization power supply voltage Vint1 described with reference to FIG. 7. The first initialization power supply voltage Vint1 may be a direct current voltage with a constant voltage level. In a plan view, the second sub-electrode SUE2 of the second vertical bridge line BRL2_V supplied with the first initialization power supply voltage Vint1 may be disposed between a seventeenth wire WL17 (or a readout line) and a third data line D3 to reduce or prevent a coupling cap that may occur between the seventeenth wire WL17 and the third data line D3.

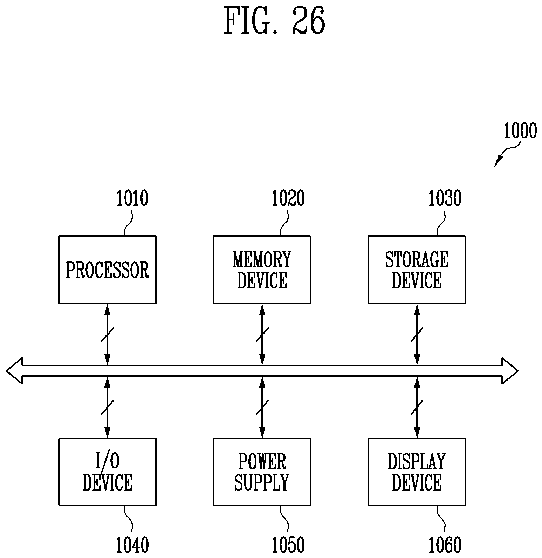

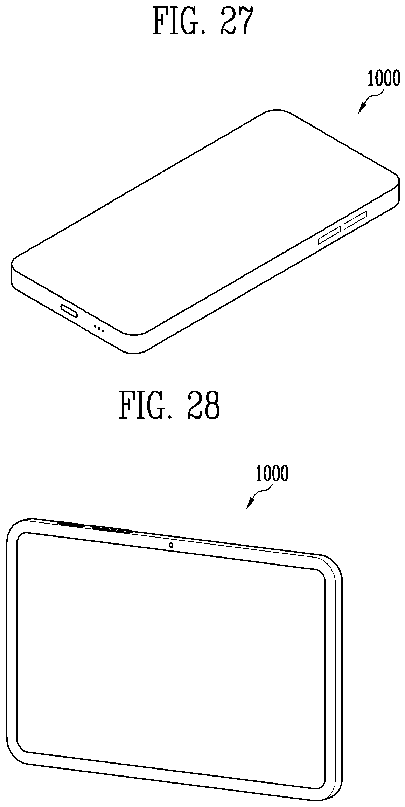

FIG. 26 is a schematic block diagram illustrating an electronic device 1000 according to one or more embodiments, FIG. 27 is a schematic drawing illustrating an example of the electronic device 1000 of FIG. 26 implemented as a smartphone, and FIG. 28 is a schematic drawing illustrating an example of the electronic device 1000 of FIG. 26 implemented as a tablet PC.

Referring to FIGS. 26 - 28, the electronic device 1000 may include a processor 1010, a memory device 1020, a storage device 1030, an input/output (I/O) device 1040, a power supply 1050, and a display device 1060. In this case, the display device 1060 may be the display device DD of FIGS. 1 and 2. The electronic device 1000 may further include multiple ports capable of communicating with a video card, a sound card, a memory card, a USB device, or other systems. In one or more embodiments, as shown in FIG. 27, the electronic device 1000 may be implemented as a smartphone. In one or more other embodiments, as shown in FIG. 28, the electronic device 1000 may be implemented as a tablet PC. However, these are examples and the electronic device 1000 is not limited to the above-described examples. For example, the electronic device 1000 may be implemented as a cellular phone, a video phone, a smart pad, a smart watch, a car navigation, a computer monitor, a laptop, a head-mounted display devices, and/or the like.

The processor 1010 may perform particular calculations or tasks. According to one or more embodiments, the processor 1010 may be a microprocessor, a central processing unit, an application processor, and/or the like. The processor 1010 may be connected to other components via an address bus, a control bus, and/or a data bus. According to one or more embodiments, the processor 1010 may also be connected to an expansion bus, such as a Peripheral Component Interconnect (PCI) bus.

The memory device 1020 may store data necessary for operations of the electronic device 1000. For example, the memory device 1020 may include a non-volatile memory device such as an Erasable Programmable Read-Only Memory (EPROM) device, an Electrically Erasable Programmable Read-Only Memory (EEPROM) device, a flash memory device, a Phase Change Random Access Memory (PRAM) device, a Resistance Random Access Memory (RRAM) device, a Nano Floating Gate Memory (NFGM) device, a Polymer Random Access Memory (PoRAM) device, a Magnetic Random Access Memory (MRAM), and a Ferroelectric Random Access Memory (FRAM) device, and/or a volatile memory device such as a Dynamic Random Access Memory (DRAM) device, a Static Random Access Memory (SRAM) device, and/or a mobile DRAM device.

The storage device 1030 may include a solid state drive (SSD), a hard disk drive (HDD), a CD-ROM, and the like.

The input/output device 1040 may include input means such as keyboard, keypad, touchpad, touchscreen, and/or mouse, and output means such as speakers and/or printers. According to one or more embodiments, the display device 1060 may be included in the input/output device 1040.

The power supply 1050 may supply power required for the operations of the electronic device 1000. For example, the power supply 1050 may be a power management integrated circuit (PMIC).

The display device 1060 may display an image corresponding to visual information of the electronic device 1000. At this time, the display device 1060 may be an organic light-emitting display or a quantum dot light-emitting display, but is not limited thereto. The display device 1060 may be connected to other components via buses and/or other communication links.

Although the present disclosure has been described with reference to embodiments above, a person skilled in the art or a person with a general knowledge of the technical field will appreciate that the present disclosure can be modified and changed in various ways without departing from the technical scope of the present disclosure as set forth in the appended claims and their equivalents.

Therefore, the technical scope of the present disclosure should not be limited to what is described in the detailed description of the specification, but is determined by the appended claims and their equivalents.

## Claims

1. A display device (DD, 1060) comprising:
a first sub-pixel (SPX1), a second sub-pixel (SPX2), and a third sub-pixel (SPX3) arranged along a first direction (DR1), each of the first to third sub-pixels (SPX1 - SPX3) comprising a pixel circuit (PXC);
a light-sensing pixel (PSR) comprising a sensor circuit (SC);
a data line (D) electrically connected to each of the second and third sub-pixels (SPX2, SPX3);
a readout line (RX) electrically connected to the light-sensing pixel (PSR);
a horizontal bridge line (BRL1_H, BRL2_H) extending along the first direction (DR1);
a first vertical bridge line (BRL1_V) extending in a second direction (DR2) and is located in the second sub-pixel (SPX2); and
a second vertical bridge line (BRL2_V) extending in the second direction (DR2) and is located in the third sub-pixel (SPX3),
wherein the second vertical bridge line (BRL2_V) comprises a first sub-electrode (SUE1) and a second sub-electrode (SUE2) that are spaced from each other.

2. The display device (DD, 1060) according to claim 1,
wherein the first sub-electrode (SUE1) is electrically connected to the horizontal bridge line (BRL1_H, BRL2_H); and/or
wherein the first sub-electrode (SUE1) and the second sub-electrode (SUE2) are electrically disconnected from each other.

3. The display device according to claim 1 or 2,
wherein the data line (D), the first vertical bridge line (BRL1_V), and the second vertical bridge line (BRL2_V) are arranged at a same layer; and/or
wherein, in a plan view, the second vertical bridge line (BRL2_V) is between the readout line (RX) and the data line (D) of the third sub-pixel (SPX3).

4. The display device (DD, 1060) according to any one of the preceding claims, further comprising:
a reset voltage wire (PL5) electrically connected to the light-sensing pixel (PSR) and configured to receive a reset voltage (VRST),
wherein the reset voltage wire (PL5) comprises:
a first wire (WL20) at a same layer as the data line (D) and the first and second vertical bridge lines (BRL1_V, BRL2_V) and spaced from each other;
a second wire (WL16) below the first wire (WL15) and electrically connected to the first wire (WL15); and
a third wire (WL15) below the second wire (WL16) and electrically connected to the second wire (WL16).

5. The display device (DD, 1060) according to claim 4, wherein the third wire (WL15) extends in the first direction (DR1), the second wire (WL16) extends in the second direction (DR2), and the first wire (WL20) extends in the second direction (DR2), and
wherein the reset voltage wire (PL5) forms a mesh structure.

6. The display device (DD, 1060) according to any one of claims 1 to 5, further comprising:
a first power wire (PL1) electrically connected to each of the first to third sub-pixels (SPX1 - SPX3) and configured to receive a first driving voltage;
a second power wire (PL2) electrically connected to each of the first to third sub-pixels (SPX1 - SPX3) and configured to receive a second driving voltage; and
a third power wire (PL3) electrically connected to each of the first to third sub-pixels (SPX1 - SPX3) and configured to receive a third driving voltage,
wherein each of the first driving voltage, the second driving voltage, and the third driving voltage is a direct current voltage having a constant voltage level.

7. The display device (DD, 1060) according to claim 6, wherein the second sub-electrode (SUE2) is electrically connected to only a single one of or at least one of the first power wire (PL1), the second power wire (PL2), or the third power wire (PL3).

8. The display device (DD, 1060) according to any one of claims 1 to 5, further comprising:
a power wire (PL) electrically connected to each of the first to third sub-pixels (SPX1 - SPX3) and configured to receive a first driving voltage,
wherein the second sub-electrode (SUE2) is electrically connected to the power wire (PL).

9. The display device (DD, 1060) according to any one of the preceding claims, wherein
the light-sensing pixel (PSR) is located between the second sub-pixel (SPX2) and the third sub-pixel (SPX3).

10. The display device (DD, 1060) according to any one of the preceding claims, wherein each of the first sub-pixel (SPX1), the second sub-pixel (SPX2), and the third sub-pixel (SPX3) comprises a light-emitting element (LED) configured to emit light, and
wherein the light-sensing pixel (PSR) comprises a light-receiving element (LRD) configured to output a sensing signal corresponding to the light.

11. The display device (DD, 1060) according to any one of the preceding claims, wherein the first sub-electrode (SUE1) and the second sub-electrode (SUE2) are electrically disconnected and located in a same column along the second direction (DR2).

12. The display device (DD, 1060) according to any one of the preceding claims, further comprising:
a first via layer (INS7) on the horizontal bridge line (BRL1_H, BRL2_H) and comprising a first via hole (VIH1) exposing an area of the horizontal bridge line (BRL1_H, BRL2_H);
a pad electrode (PDE) on the first via layer (INS7) and electrically connected to the horizontal bridge line (BRL1_H, BRL2_H) through the first via hole (VIH1); and
a second via layer (INS8) on the pad electrode (PDE) and comprising a second via hole (VIH2) exposing an area of the pad electrode (PDE),
wherein, in a plan view, the second vertical bridge line (BRL2_V) is separated into the first sub-electrode (SUE1) overlapping the second via hole (VIH2) near the second via hole (VIH2) and the second sub-electrode (SUE2) not overlapping the second via hole (VIH2).

13. The display device (DD, 1060) according to any one of the preceding claims, further comprising:
a substrate (SUB);
a first, a second, a third, a fourth, a fifth, a sixth, a seventh, an eighth, and a ninth insulating layers (INS1 - INS9) sequentially located on the substrate (SUB);
a first conductive layer (CL1) between the second insulating layer (INS2) and the third insulating layer (INS3);
a second conductive layer (CL2) between the third insulating layer (INS3) and the fourth insulating layer (INS4);
a third conductive layer (CL3) between the fifth insulating layer (INS5) and the sixth insulating layer (INS6);
a fourth conductive layer (CL4) between the sixth insulating layer (INS6) and the seventh insulating layer (INS7);
a fifth conductive layer (CL5) between the seventh insulating layer (INS7) and the eighth insulating layer (INS8); and
a sixth conductive layer (CL6) between the eighth insulating layer (INS8) and the ninth insulating layer (INS9),
wherein the fourth conductive layer (CL4) comprises the horizontal bridge line (BRL1_H, BRL2_H), the fifth conductive layer (CL5) comprises the readout line (RX), and the sixth conductive layer (CL6) comprises the first and second vertical bridge lines (BRL1_V, BRL2_V) and the data line (D).

14. The display device (DD, 1060) according to any one of the preceding claims, wherein the second sub-electrode (SUE2) is a shielding member that prevents a coupling cap between the readout line (RX) and the data line (D) of the third sub-pixel (SPX3).

15. An electronic device (1000) comprising:
a processor (1010) configured to provide input image data to a display device (DD, 1060); and
the display device (DD, 1060) according to any one of the preceding claims and configured to display an image based on the input image data.
